(19) Europäisches Patentamt
European Patent Office
Office européen des brevets

(11) **EP 2 224 465 B1**

(12) **EUROPÄISCHE PATENTSCHRIFT**

(45) Veröffentlichungstag und Bekanntmachung des Hinweises auf die Patenterteilung:
**12.10.2016  Patentblatt 2016/41**

(51) Int Cl.:
**_H01J 37/26_** _(2006.01)_

(21) Anmeldenummer: **10001638.5**

(22) Anmeldetag: **18.02.2010**

(54) **Verfahren und Vorrichtung zur Bildkontrasterzeugung durch Phasenschiebung**

Method and device for creating image contrast with the use of phase shifting

Procédé et dispositif de génération de contraste d'image par décalage de phase

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **26.02.2009  DE 102009010774**

(43) Veröffentlichungstag der Anmeldung:
**01.09.2010  Patentblatt 2010/35**

(73) Patentinhaber: **Ceos Corrected Electron Optical Systems GmbH**
**69126 Heidelberg (DE)**

(72) Erfinder:
• **Zach, Joachim, Dr.**
**76684 Östringen (DE)**

• **Rose, Harald, Prof. Dr.**
**64287 Darmstadt (DE)**

(74) Vertreter: **Weber & Seidel**
**Rechts- und Patentanwälte**
**Handschuhsheimer Landstraße 2a**
**69120 Heidelberg (DE)**

(56) Entgegenhaltungen:
WO-A1-2007/065382     DE-A1-102006 055 510
DE-A1-102007 007 923

• **ROSE ET AL: "Theoretical aspects of image formation in the aberration-corrected electron microscope", ULTRAMICROSCOPY, ELSEVIER, AMSTERDAM, NL, Bd. 110, Nr. 5, 1. April 2010 (2010-04-01) , Seiten 488-499, XP027027881, ISSN: 0304-3991 [gefunden am 2009-10-21]**

## Beschreibung

Die Erfindung betrifft ein Verfahren zur Bildkontrasterzeugung durch Phasenschiebung in der Elektronenoptik, wobei ausgehend von einem Zwischenbild durch Quadrupolfelder eine anamorphotische Abbildung der Axialstrahlen bei gleichzeitigem Nulldurchgang der Feldstrahlen in mindestens einer Beugungs- Zwischenbildebene erzeugt wird, dort durch ein magnetisches oder elektrisches Feld eine relative Phasenschiebung zwischen einem Bereich um den Elektronenstrahl nullter Beugungsordnung und den Elektronenstrahlen höherer Beugungsordnungen bewirkt wird und danach durch weitere Quadrupolfelder die mindestens eine erzeugte Anamorphie des Strahlengangs wieder kompensiert wird.

Die Erfindung betrifft weiterhin eine Vorrichtung zur Durchführung des Verfahrens mit eingangsseitigen Quadrupolelementen, die ausgehend von einem Zwischenbild derartige Quadrupolfelder erzeugen, daß die Axialstrahlen und die Feldstrahlen in zwei senkrechten Schnitten derart fokussiert bzw. defokussiert werden, daß in einer Beugungs-Zwischenbildebene die Axialstrahlen eine anamorphotische Abbildung bilden und die Feldstrahlen jeweils durch Null gehen, wobei im Bereich der Beugungs-Zwischenbildebene ein zentrales Quadrupolelement mit einem derartigen Quadrupolfeld angeordnet ist, daß die Axialstrahlen das Feld mit Steigungen verlassen, die gegenüber dem Eintritt in das Feld entgegengesetzt verlaufen, und wobei zwei weitere Quadrupolelemente Quadrupolfelder erzeugen, die zu den Quadrupolfeldern der eingangsseitigen Quadrupolelemente betrags- und vorzeichengleich sind, so daß die Anamorphie des Strahlengangs wieder kompensiert wird, und wobei in der Beugungs-Zwischenbildebene ein phasenschiebendes Element angeordnet ist, dessen magnetisches oder elektrisches Feld derart eingerichtet ist, daß eine relative Phasenschiebung zwischen dem Bereich des Elektronenstrahls nullter Beugungsordnung und den Elektronenstrahlen höherer Beugungsordnungen bewirkt wird.

Und die Erfindung betrifft eine Vorrichtung zur Durchführung eines Verfahrens mit eingangsseitigen Quadrupolelementen, die ausgehend von einem Zwischenbild derartige Quadrupolfelder erzeugen, daß die Axialstrahlen und die Feldstrahlen in zwei senkrechten Schnitten derart fokussiert bzw. defokussiert werden, daß in einer Beugungs-Zwischenbildebene die Axialstrahlen eine anamorphotische Abbildung bilden und die Feldstrahlen jeweils durch Null gehen, wobei im Bereich der Beugungs- Zwischenbildebene ein zentrales Quadrupolelement mit einem derartigen Quadrupolfeld angeordnet ist, daß die Axialstrahlen das Feld mit entgegengesetzten Steigungen verlassen, wie sie in das Feld eingetreten sind, und wobei in der Beugungs- Zwischenbildebene ein erstes phasenschiebendes Element angeordnet ist, dessen magnetisches oder elektrisches Feld derart eingerichtet ist, daß eine relative Phasenschiebung zwischen dem Bereich des Elektronenstrahls nullter Beugungsordnung und den Elektronenstrahlen höherer Beugungsordnungen bewirkt wird.

Wie in der Lichtmikroskopie sind auch in der Elektronenmikroskopie viele Objekte für den Strahl nahezu transparent, so daß bei konventioneller Abbildung nur wenig Amplitudenkontrast entsteht. Sowohl der Axialstrahl als auch die Feldstrahlen erfahren beim Durchgang durch das Objekt aber eine von der Struktur des Objekts abhängige ortsveränderliche Phasenschiebung. Der Strahl spaltet sich hierdurch im Objekt in einen ungebeugten sogenannten Nullstrahl und in gebeugte Strahlen mehrerer Beugungsordnungen auf.

Beaufschlagt man den Nullstrahl mit einer Phasenschiebung, bevorzugt 90°, so wird bei der Wiederüberlagerung des Nullstrahls mit den gebeugten Strahlen in der Bildebene die Phasenmodulation des Objekts durch die Interferenz bei der Wiederüberlagerung in einen starken Amplitudenkontrast umgewandelt. Dies ist der bekannte Phasenkontrast (siehe z. B. Reimer, Kohl, "Transmission Electron Microscopy", S. 211 ff, 5. Auflage, 2008). Für eine solche Phasenschiebung nutzt man die Tatsache, daß die Strahlen in der Brennebene des Objektivs verschiedene Brennpunkte bilden, so daß in der Brennebene für den Nullstrahl dieser einen zentralen Brennpunkt bildet und von den Brennpunkten der gebeugten Strahlen der verschiedenen Beugungsordnungen, beginnend mit der Beugung erster Ordnung umgeben wird, die im Wesentlichen in der gleichen Brennebene liegen. Diese Tatsache kann man dazu nutzen, eine Phasenschiebung entweder des Nullstrahls oder der gebeugten Strahlen herbeizuführen, um den Phasenunterschied aufzuheben, damit sich die Amplituden verstärken.

Im Gegensatz zur Lichtoptik besteht bei Elektronenstrahlen jedoch das Problem, daß es für sie keine transparente Platte gibt, die eine Phasenplatte tragen kann. Zur Lösung dieses Problems wurden daher phasenschiebende Elemente verschiedenster Art vorgeschlagen, die darauf beruhen, daß das phasenschiebende Element durch den Bereich der gebeugten Strahlen hindurchgreift, um den Bereich des Nullstrahls zu erfassen. Dazu ist noch anzumerken, daß es technisch nicht realisierbar ist, allein den Nullstrahl zu erfassen, da ein elektrisches Feld im Nanometerbereich erforderlich wäre, was mit den derzeitigen technischen Möglichkeiten nicht erzeugt werden kann. Darum werden je nach Ausgestaltung der jeweiligen phasenschiebenden Elemente zumindest in geringem Ausmaß gebeugte Strahlen miterfaßt. Bei vielen dieser Vorschläge weist das phasenschiebende Element eine Ringstruktur auf, die den Bereich des Nullstrahls umfaßt, um dort das für die Phasenschiebung des Nullstrahls erforderliche Feld zu applizieren. Dabei werden jedoch in nicht unerheblichem Maß gebeugte Strahlen abgeschattet, die für die Kontrasterzeugung verlorengehen. Deshalb wurde von der DE 10 2006 055 510 A1 ein phasenschiebendes Element vorgeschlagen, das einseitig an den Bereich des Nullstrahls heranreicht, um dort das erforderliche Feld zu applizieren. Da es auf diese Weise zu keiner Abschattung von Bereichen kommt, die um 180° versetzt einander gegenüberliegen, ist es bei diesem phasenschiebenden Element möglich, die abgeschatteten Anteile der gebeugten Strahlen zu rekonstruieren, und sie so voll für die Kontrasterzeugung zu nutzen.

Eine andere Lösung dieses Problems sind phasenschiebende Elemente der eingangs genannten Art, die von der DE 10 2007 007 923 A1 vorgeschlagen wurden. Sie arbeiten nach dem eingangs genannten Verfahren, das darauf beruht, daß durch Quadrupolfelder eine anamorphotische Abbildung in einem Beugungs- Zwischenbild erzeugt wird, die es ermöglicht, an den Nullstrahl oder an die gebeugten Strahlen mit einem Feld heranzukommen, um eine relative Phasenschiebung zwischen dem Bereich um den Elektronenstrahl nullter Beugungsordnung und den Elektronenstrahlen höherer Beugungsordnung herbeizuführen. Auf diese Weise wird erreicht, daß kein Bauteil der Vorrichtung gebeugte Strahlen abschattet. Dies hat den weiteren Vorteil, daß die getrennte Erfassung dieser Strahlenanteile und damit die Kontrasterzeugung wesentlich besser möglich ist. Nullstrahl und gebeugte Strahlen sind in der anamorphotischen Abbildung von der Mitte nach außen aufgereiht, so daß es möglich ist, sowohl den Nullstrahl als auch die gebeugten Strahlen relativ exakt mit einem Feld zu erfassen. Dabei ist es jedoch nicht möglich, die Länge der anamorphotischen Abbildung für eine gute Erfassung des Nullstrahls oder der gebeugten Strahlen beliebig auszudehnen, da einer solchen Ausdehnung zum einen gerätetechnisch durch die Größe der Röhre des Elektronenmikroskops, die das elektronenoptische System enthält, Grenzen gesetzt sind, zum anderen dadurch, daß die Ausweitung der Länge der anamorphotischen Abbildung bei größerer Ausdehnung nicht mehr tolerierbare Fehler verursacht, so daß auf diese Weise die erstrebte hohe Bildqualität wieder verlorengehen würde.

Daher liegt der Erfindung die Aufgabe zugrunde, bei dem Verfahren und den beiden Vorrichtungen der eingangs genannten Art den Bildkontrast weiter zu verbessern, ohne dabei nicht mehr tolerierbare Fehler zu verursachen.

Die Aufgabe wird bezüglich des Verfahrens der eingangs genannten Art erfindungsgemäß dadurch gelöst, daß zur Erzeugung und Kompensation der mindestens einen anamorphotischen Abbildung unmittelbar vor und nach dieser Abbildung angeordnete Quadrupolelemente dienen, die eine derartige Ausdehnung in Richtung der optischen Achse und eine derartige Stärke aufweisen, daß sie ein astigmatisches Zwischenbild in ihrem Wirkungsbereich erzeugen , wobei die Stärke derart groß gewählt ist, daß sich die axiale Feldausdehnung in das optische System eines Elektronenmikroskops einfügen läßt, und wobei mindestens einer der Axialstrahlen durch die entsprechende Wahl einer starken Vergrößerung M des Zwischenbildes unter einer derart geringen Steigung 1/M in das Quadrupolfeld des Quadrupolelementes unmittelbar vor der mindestens einen anamorphotischen Abbildung einläuft, daß ihr Aspektverhältnis deutlich vergrößert wird, jedoch die Länge der anamorphotischen Abbildung nicht derart überschritten wird, daß sich die Bildqualität in einer Weise verschlechtert, die für die Bildauswertung in irgend einer Weise nachteilig wäre.

Eine erste erfindungsgemäße Vorrichtung ist in Anspruch 11 angegeben. Die Aufgabe wird bezüglich der ersten Vorrichtung der eingangs genannten Art dadurch gelöst, daß die der Beugungs- Zwischenbildebene unmittelbar vor- und nachgeordneten Quadrupolelemente eine Ausdehnung in Richtung der optischen Achse und eine derartige Stärke aufweisen, daß sie ein astigmatisches Zwischenbild in ihrem Wirkungsbereich erzeugen, wobei die Stärke derart groß gewählt ist, daß sich die axiale Feldausdehnung unter Einhaltung einer akzeptablen Bauhöhe in das optische System eines Elektronenmikroskops an eine Stelle des Strahlengangs des Projektivlinsensystems einfügen läßt, und wobei mindestens einer der Axialstrahlen durch die entsprechende Wahl einer starken Vergrößerung M des Zwischenbildes unter einer derart geringen Steigung - in das Quadrupolfeld vor der mindestens einen anamorphotischen Abbildung einläuft, daß ihr Aspektverhältnis deutlich vergrößert wird, jedoch die Länge der anamorphotischen Abbildung nicht derart überschritten wird, daß sich die Bildqualität in einer Weise verschlechtert, die für die Bildauswertung in irgend einer Weise nachteilig wäre.

Eine zweite erfindungsgemäße Vorrichtung ist in Anspruch 14 angegeben. Die Aufgabe wird bezüglich der zweiten Vorrichtung der eingangs genannten Art dadurch gelöst, daß der Beugungs- Zwischenbildebene ein Quadrupolelement nachgeordnet ist und die der Bengungs - Zwischenbildebene unmittelbar von- und nach geordneten Quadrupolelemente eine derartige Ausdehnung in Richtung der optischen Achse und eine derartige Stärke aufweisen, daß sie ein astigmatische Zwischenbild in ihrem Wirkungsbereich erzeugen, wobei die Stärke derart groß gewählt ist, daß sich die axiale Feldausdehnung unter Einhaltung einer akzeptablen Bauhöhe in das optische System eines Elektronenmikroskops einfügen läßt, daß nach einer bezüglich aller Quadrupolelemente zentralen Symmetrieebene drei Quadrupolelemente folgen, deren Felder im Wesentlichen betragsgleich zu den Feldern der davorliegenden drei Quadrupolelemente jedoch um 90° gedreht sind, daß dann ein Quadrupol mit einem Feld folgt, das betragsgleich aber um 90° gedreht zum Feld des ersten Quadrupols ist, daß die Felder und der vor und nach der Beugungs- Zwischenbildebene liegenden Quadrupolelemente derart voneinander abweichend einstellbar sind, daß die Axialstrahlen in der zentralen Symmetrieebene ein weiteres Zwischenbild der Vergrößerung M bilden und sich die Feldstrahlen schneiden, und wobei die entsprechenden Quadrupolelemente nach der zentralen Symmetrieebene, deren Felder um 90° gedreht sind, ebenfalls abweichend einstellbar sind, so daß am Ende der Vorrichtung ein drittes Zwischenbild der Größe M entsteht, so daß die Axialstrahlen und die Feldstrahlen diese Felder im x-Schnitt so durchlaufen wie die ersten vier Felder im y-Schnitt und im y-Schnitt wie zuvor im x-Schnitt, wobei im zweiten zentralen Quadrupolelement eine zweite Beugungs- Zwischenbildebene mit einer weiteren anamorphotischen Abbildung entsteht, die zur ersten anamorphotischen Abbildung um 90° gedreht ist, daß in der zweiten Beugungs- Zwischenbildebene ein zweites phasenschiebendes Element angeordnet ist, dessen magnetisches oder elektrisches Feld derart eingerichtet ist, daß eine relative Phasenschiebung zwischen einem Bereich des Elektronenstrahls nullter Beugungsordnung und den Elektronenstrahlen höherer Beugungsordnungen bewirkt wird, und daß die Vorrichtung für eine Anordnung an einer Stelle des Strahlengangs eines Projektivlinsensystems eines Elektronenmikroskops angeordnet ist, an der die Axialstrahlen ein Zwischenbild mit einer so starken Vergrößerung M bilden, daß sie in das Quadrupolfeld des zweiten Quadrupols unmittelbar vor der anamorphotischen Abbildung mit einer derartigen Steigung $\frac{1}{M}$ einlaufen, daß ihr Aspektverhältnis deutlich vergröbert wird, jedoch die Länge der anamorphotischen Abbildung nicht derart überschritten wird, daß sich die Bildqualität in einer Weise verschlechtert, die für die Bildauswertung in irgend einer Weise nachteilig wäre.

Der Erfindung liegt zunächst die Erkenntnis zugrunde, daß es für eine gute Phasenkontrasterzeugung nicht nur auf die Länge der anamorphotischen Abbildung ankommt, sondern auch auf das Verhältnis von dessen Länge zu dessen Breite, also auf das Aspektverhältnis. Je größer dieses Aspektverhältnis ist, je besser gelingt eine möglichst reine Nullstrahlerfassung oder eine Erfassung möglichst aller Beugungsordnungen, insbesondere der ersten, die dem Nullstrahl am nächsten liegt.

In Anbetracht dieser Erkenntnis konnte also ausgehend von der oben genannten Aufgabe das Ziel dahin definiert werden, daß man nur eine Länge der anamorphotischen Abbildung zuläßt, durch die noch keine nicht tolerierbaren Fehler entstehen, dafür aber Maßnahmen ergreift, durch die das Aspektverhältnis deutlich vergrößert werden kann. Unter tolerierbare Fehler sind dabei solche zu verstehen, welche die Bildqualität nicht in einer Weise verschlechtern, die für die Bildauswertung in irgendeiner Weise nachteilig ist.

Bei Einhaltung der oben genannten Länge der anamorphotischen Abbildung stehen drei Parameter für die Erzielung eines großen Aspektverhältnisses zur Verfügung: Dies ist zunächst die Ausdehnung der Quadrupolelemente in axialer Richtung und damit auch der Quadrupolfelder, die vor der oder den Beugungs- Zwischenbildebenen liegen, und selbstverständlich in gleichem Maße bei dem oder den Quadrupolelementen beziehungsweise Quadrupolfeldern danach, um die bewußt herbeigeführte Abbildungsverzerrung wieder zu kompensieren. Dabei hat sich gezeigt, daß für die Erzielung des angestrebten großen Aspektverhältnisses eine Ausdehnung in axialer Richtung erforderlich ist, bei der bei entsprechender Feldstärke ein astigmatisches Zwischenbild im Wirkungsbereich der Quadrupolfelder entstehen kann. Mit dieser axialen Ausdehnung ist dann natürlich die Feldstärke der Quadrupolelemente, verknüpft. Durch entsprechend große Feldstärken wird dabei vermieden, daß die Quadrupolelemente in einer gerätetechnisch unerwünschten Länge gebaut werden müssen. Die Feldstärken müssen also so groß sein, daß die Bauhöhen der entsprechenden Vorrichtungen die Längen der Strahlröhren üblicher Elektronenmikroskope nicht derart erhöhen, daß diese in dafür üblichen Räumen nicht mehr aufstellbar sind.

Schließlich ist es noch erforderlich, daß die Axialstrahlen mit einer bestimmten Steigung in die Quadrupolfelder vor der oder den Beugungs- Zwischenbildebenen eintreten, um ein großes Aspektverhältnis unter Einhaltung der genannten Länge der anamorphotischen Abbildung und bei einer handhabbaren Größe der Vorrichtung zu erzielen. Nach dem Helmholtzschen Satz (Prof. Rose "Geometrical Charged-Particle Optics", S. 81 ff) gilt das Gesetz, daß von einem Zwischenbild mit einer Abbildung in einer Vergrößerung M Axialstrahlen mit einer Steigung $\frac{1}{M}$ ausgehen, die dann zu einem um M verkleinerten Beugungs- Zwischenbild führen (Rose, a.a.O. S. 82, "Lagrange-Helmholtz formula"). Einfach ausgedrückt hat eine große Vergrößerung des Zwischenbildes eine flache Steigung der Axialstrahlen und diese wiederum ein entsprechend verkleinertes Beugungsbild zur Folge. Durch entsprechende Wahl der Vergrößerung M des Zwischenbildes kann somit also die Steigung $\frac{1}{M}$ der Axialstrahlen gewählt werden und damit ein derart kleines virtuelles Beugungsbild, daß dann in der Beugungs- Zwischenbildebene eine anamorphotische Abbildung mit einem großen Aspektverhältnis und somit mit einer akzeptablen Länge erzielt werden kann. Die anamorphotische Abbildung wird dabei aus Axialstrahlen mit der Steigung $\frac{1}{M}$ erzeugt, die ohne Anordnung der Quadrupolfelder zu dem stark verkleinerten Beugungsbild führen würden. Da jedoch die Quadrupolfelder vorher ihre Wirkung entfalten, bleibt dieses virtuell und die Quadrupolfelder beeinflussen die Axialstrahlen derart, daß die anamorphotische Abbildung in der Beugungs- Zwischenbildebene entsprechend verkleinert ist, so daß sie bei noch handhabbarer Länge äußerst schmal ist, also ein großes Aspektverhältnis besitzt. Bei diesem befindet sich in der Mitte der Nullstrahl und nach außen sind die gebeugten Strahlen aufgereiht. Dadurch kann eine optimale Phasenschiebung des Nullstrahls oder der gebeugten Strahlen ohne Bildverschlechterung und ohne Überschreitung einer akzeptablen Baugröße erzielt werden.

Werden dagegen Quadrupolfelder eingesetzt, deren axiale Ausdehnung weit unter der oben definierten liegt, wie dies beispielsweise der DE 10 2007 007 923 A1, Fig. 17 und 18 zu entnehmen ist, kann kein Aspektverhältnis erzielt werden, das größer als 10 ist, außer man nimmt eine Länge der anamorphotischen Abbildung in Kauf, bei der Fehler verursacht werden, die die Bildqualität spürbar verschlechtern. Dies wäre dann aber auch gerätetechnisch nicht handhabbar, da eine Vergrößerung des Durchmessers der Strahlröhre eines Elektronenmikroskops für die Unterbringung einer sehr langen anamorphotischen Abbildung nicht akzeptabel ist. Vielmehr muß sich die Vorrichtung nach den üblichen Abmessungen von Elektronenmikroskopen richten, um von deren Herstellern als einzubauende Funktionselemente akzeptiert zu werden.

Die Erfindung strebt dagegen zur Erzielung kontrastreicher Bilder Aspektverhältnisse an, die über 100 oder möglichst sogar über 200 liegen, und dies ohne Bildverschlechterung und bei einer Größe der Vorrichtung, die gerätetechnisch handhabbar und akzeptabel ist. Dies ist nur mittels der oben genannten Maßnahmen möglich, insbesondere kann eine von einem großen Zwischenbild (der Vergrößerung M) ausgehende flache Steigung der Axialstrahlen $\frac{1}{M}$ nur dann zur Erzielung einer anamorphotischen Abbildung mit einem Aspektverhältnis von über 100 genutzt werden, wenn das Quadrupolelement vor der Beugungs-Zwischenbildebene bzw. dessen Feld die oben definierte axiale Ausdehnung hat, so daß eine akzeptable Bauhöhe zustande kommt. Wird noch eine zweite anamorphotische Abbildung erzeugt, gilt für diese aufgrund der Antisymmetriebedingungen für den Strahlenverlauf dasselbe, diese werden noch näher erläutert.

Die erfindungsgemäßen Vorrichtungen müssen dabei an den jeweiligen Bautyp eines Elektronenmikroskops angepaßt werden. Entsprechend dieses Bautyps sucht man auch die Stelle im Projektivlinsensystem mit der Vergrößerung M des Zwischenbildes für den Einbau der Vorrichtung in der angegebenen Weise aus. Wie groß diese Vergrößerung von M gewählt wird, richtet sich wiederum nach dem Bautyp des Elektronenmikroskops. Bei Elektronenmikroskopen mit hoher Auflösung und großer Vergrößerung wird man ein höheres Aspektverhältnis von 200 und mehr anstreben und daher auch eine größere Vergrößerung M wählen wie bei Geräten, von denen weniger gefordert wird. Sind die Anforderungen an Elektronenmikroskope geringer, ist auch der Durchmesser des Strahlsrohrs geringer und die Bauhöhe des Geräts ist derart, daß es in einem Arbeitsraum mit üblicher Deckenhöhe aufgestellt werden kann. Hier reicht eine kleinere Vergrößerung M des Zwischenbildes und ein kleineres Aspektverhältnis. Es muß jedoch auch die Länge der anamorphotischen Abbildung kürzer sein und die Brennweiten der der Beugungs- Zwischenbildebene vor- und nachgeordneten Quadrupole müssen zur Eingrenzung ihrer Bauhöhe ebenfalls kürzer sein. Dies muß alles der geringeren Bauhöhe und dem kleineren Strahlrohrdurchmesser eines solchen Geräts Rechnung tragen. Die Geräte mit höheren Anforderungen weisen Strahlrohre mit wesentlich größerem Durchmesser auf, da die Ausmaße der Linsen entsprechend den breiteren Strahlenbündeln größer sind. Solche Geräte haben auch eine größere Bauhöhe und für ihre Aufstellung stehen daher auch Räume zur Verfügung, die eine entsprechend größere Deckenhöhe aufweisen. Dies erlaubt die vorgenannten Dimensionierungen zu vergrößern, entsprechend größer sind aber auch die Anforderungen an den zu erzielenden Phasenkontrast.

Je nach den vorgenannten Gegebenheiten und den erwünschten Anforderungen müssen dann die relativen Größenangaben der Merkmale der erfindungsgemäßen Vorrichtungen gewählt werden. Bei einem hochauflösenden Elektronenmikroskop könnte man beispielsweise ein Aspektverhältnis von 400 wählen. Um ein so großes Aspektverhältnis zu handhaben, sollte man aber auch eine größere Länge der anamorphotischen Abbildung wählen. Bei einem Strahlrohr mit großem Durchmesser kann die anamorphotische Abbildung auch eine solche größere Länge aufweisen, ohne nicht tolerierbare Fehler zu verursachen. Entsprechend würde man ein Zwischenbild mit großer Vergrößerung wählen und die anamorphotischen Abbildung derart wählen, daß entsprechend der Beschleunigungsspannung und dem Strahlengang des jeweiligen Geräts die Länge der anamorphotischen Abbildung innerhalb des gegebenen Röhrendurchmessers des Strahlrohrs einerseits baulich möglich ist, sich aber andererseits daran orientiert, daß die Fehlerverursachung das tolerierbare Ausmaß nicht überschreitet.

Damit stehen dem Fachmann durch den jeweiligen Bautyp des Elektronenmikroskops, dessen Größe und den Anforderungen an dieses Gerät auch die Parameter zur Verfügung, nach denen er die relativen Angaben für jeden Bautyp konkretisieren kann.

Bei den Quadrupolfeldern kann es sich in bekannter Weise um magnetische oder elektrische Felder handeln, dies spielt für das Funktionsprinzip keine Rolle. Auch für die Phasenschiebung können elektrische oder magnetische Felder eingesetzt werden, wobei man hier elektrische Felder bevorzugt. Zum einen deshalb, weil man hierfür keine besonders starken Felder benötigt, zum anderen deshalb, weil sich elektrische Felder besser in definierter und begrenzter örtlicher Ausdehnung applizieren lassen.

Bezüglich des Verfahrens kann im einfachsten Fall unter Einsatz von mindestens fünf Quadrupolfeldern eine einzige anamorphotische Abbildung erzeugt und wieder kompensiert werden. Dann ist es am zweckmäßigsten, wenn das dort applizierte magnetische oder elektrische Feld eine derartige Feldstärke aufweist, daß eine relative Phasenschiebung von näherungsweise 90° bewirkt wird. Dies schließt jedoch nicht aus, daß bei bestimmten Objekten durch eine abweichende Phasenschiebung eine bessere Kontrastbildung erzielt wird. Darum kann diesbezüglich eine Einstellbarkeit zweckmäßig sein.

Die Feldanordnung läßt sich auch verdoppeln, so daß auf die mindestens fünf Quadrupolfelder, welche den Strahl anamorphotisch verformen und anschließend die Verformung wieder rückgängig machen, nochmals mindestens fünf Quadrupolfelder folgen, die umgekehrt gepolt sind. In diesem Fall muß zwischen den beiden Feldanordnungen - also bezüglich der Elemente in der Symmetrieebene und bezüglich der Felder in der Ebene der Antisymmetrie - ein Zwischenbild sein. Damit nach dem letzten Quadrupolfeld der ersten Feldanordnung dieses weitere Zwischenbild entsteht, müssen die Felder derart angeordnet werden, daß das Zwischenbild an der Eingangsseite der Feldanordnung vor dem ersten Quadrupolfeld liegt. Sind diese Bedingungen erfüllt, so kommt es zu einem Strahlenverlauf in antisymmetrischer Weise derart, daß in der zweiten Hälfte der Vorrichtung die Axialstrahlen und die Feldstrahlen den x-Schnitt so durchlaufen, wie vorher den y-Schnitt und den y-Schnitt so, wie vorher den x-Schnitt. Auf diese Weise wird nochmals eine um 90° gedrehte anamorphotische Abbildung erzeugt und wieder kompensiert. In diesem Fall ist es zweckmäßig, wenn bei den beiden erzeugten anamorphotischen Abbildungen magnetische oder elektrische Felder zur relativen Phasenschiebung appliziert werden, die derartige Feldstärken aufweisen, daß diese jeweilige Phasenschiebung näherungsweise 45° beträgt. Selbstverständlich kann auch hier bei bestimmten Objekten eine davon abweichende Phasenschiebung zweckmäßig sein.

Bei der vorgenannten Vorgehensweise weisen die Strahlen nach dem Verlassen des auf die erste anamorphotische Abbildung folgenden Quadrupolfeldes dieselbe Steigung auf wie beim Eintritt in das der zweiten anamorphotischen Abbildung vorgeordnete Quadrupolfeld. Auf diese Weise ist es möglich, die Strahlen unmittelbar von dem der ersten anamorphotischen Abbildung folgenden Quadrupolfeld an das Quadrupolfeld zu übergeben, das der zweiten anamorphotischen Abbildung vorgeordnet ist. Auf diese Weise gibt es nur noch eine zentrale Symmetrieebene bezüglich der Quadrupolelementenanordnung, die jedoch bezüglich der Felder eine Ebene der Antisymmetrie ist. Die beiden Feldanordnungen weisen jedoch durch das Weglassen von Quadrupolfeldern jeweils in sich selbst keine Symmetrie mehr auf, was eine Abweichung in der Steigung der Strahlen im Vergleich zur oben beschriebenen doppelsymmetrischen Anordnung verursacht, so daß das Zusammenfügen der Feldanordnungen einer Einstellmöglichkeit bedarf, um eine vollständige Kompensation der jeweiligen Anamorphie zu erzielen.

Zu diesem Zweck müssen dann die Quadrupolfelder der ersten Feldanordnung, die vor und nach der Beugungs-Zwischenbildebene liegen, derart voneinander abweichend eingestellt werden, daß die Axialstrahlen in der zentralen Symmetrieebene ein weiteres Zwischenbild der Vergrößerung M bilden und sich die Feldstrahlen schneiden. Da sich jedoch am Ende der Vorrichtung ein drittes Zwischenbild der Größe M bilden muß, müssen auch die entsprechenden Quadrupolfelder, die vor und nach der zweiten Beugungs-Zwischenbildebene liegen, derart voneinander abweichend eingestellt werden, daß ein drittes Zwischenbild entsteht, das ebenfalls die Vergrößerung M aufweist.

Die vorbeschriebene Feldanordnung kann dann so aussehen, daß man, ausgehend von einer Doppelsymmetrie mit jeweils fünf Quadrupolfeldern, das letzte und das erste der jeweiligen fünf Quadrupolfelder unter den vorgenannten Bedingungen wegläßt, ohne dadurch - bei Vornahme der vorbeschriebenen Korrekturen - die Antisymmetrie des Strahlengangs und damit die Gesamtfunktion zu verändern. Bei einer größeren Anzahl von Feldern können entsprechend so viele weggelassen werden, daß eine entsprechende Antisymmetrie des Strahlenverlaufs gewährleistet ist.

Der Vorteil der letztgenannten und der vorgenannten Feldanordnungen mit einer zweimaligen Phasenschiebung von näherungsweise jeweils 45° besteht darin, daß damit bei bestimmten Strukturen ein besserer Bildkontrast erzielt wird. Auch hier gibt es jedoch bei bestimmten Objekten bezüglich des Betrags der Phasenschiebung Ausnahmen.

Die genannte relative Phasenschiebung zwischen dem Bereich des Nullstrahls und den gebeugten Elektronenstrahlen kann durch eine Feldapplikation auf beide Strahlenbereiche erfolgen, zweckmäßiger ist es jedoch, daß nur bei einer dieser Strahlenarten eine Phasenschiebung bewirkt wird. So läßt sich ein magnetisches oder elektrisches Feld nur im Bereich des Nullstrahls applizieren, um beispielsweise eine Phasenschiebung von näherungsweise 90° oder von zweimal näherungsweise 45° zu bewirken. Umgekehrt kann man das magnetische oder elektrische Feld auch nur im Bereich der gebeugten Strahlen applizieren, um dort Phasenschiebungen der eben genannten Art zu bewirken.

Die Quadrupolfelder zur Erzeugung und Kompensation der anamorphotischen Abbildung, welche unmittelbar vor und nach dieser angeordnet sind, weisen zweckmäßigerweise eine derartige Ausdehnung in Richtung der optischen Achse und eine derartige Stärke auf, daß ein astigmatisches Zwischenbild in ihrem Wirkungsbereich erzeugbar ist. Da man auf diese Weise mit der Feldstärke auch die Ausdehnung in Richtung der optischen Achse bestimmt, sollte letztere durch eine entsprechende Bemessung der Feldstärke begrenzt werden, damit das Elektronenmikroskop durch die Einfügung der nach diesem Verfahren arbeitenden Vorrichtung nicht zu einer unakzeptablen Bauhöhe des jeweiligen Bautyps des Elektronenmikroskops führt. Die Bauhöhe richtet sich nach dem jeweiligen Bautyp und den Raumhöhen der Betriebsräume, die für diese Gerätetypen üblicherweise vorgesehen werden.

Auch die Frage, ob ein Aspektverhältnis von größer als 100 oder größer als 200 gewählt wird, richtet sich nach Vergrößerung und Auflösung des jeweiligen Gerätetyps. Je höher die Anforderungen an die optischen Eigenschaften eines Geräts sind, desto größer sollte das Aspektverhältnis sein, um einen möglichst guten Bildkontrast aufgrund des Auseinanderziehens der Bereiche von Nullstrahl und gebeugten Strahlen erzielen zu können.

Die erfindungsgemäßen Vorrichtungen arbeiten nach den oben beschriebenen Verfahren. Somit gibt das Verfahren und seine Weiterbildungen die Arbeitsweise der Vorrichtungen wieder und umgekehrt kann die Offenbarung der Vorrichtungen aufgrund ihrer Arbeitsweise ergänzend zu der Beschreibung des Verfahrens herangezogen werden.

Die oben bereits beschriebene Vorrichtung betrifft zunächst einen einfachsymmetrischen Aufbau mit den beschriebenen mindestens fünf Quadrupolelementen. Diese sind für die erfindungsgemäße Phasenschiebung erforderlich, wobei selbstverständlich in eine solche Vorrichtung auch weitere Quadrupol- oder Mehrpolelemente integriert werden können, um weitere Funktionen zu bewirken, wie die Korrektur von Farbfehlern, Öffnungsfehlern oder beliebige axiale oder außeraxiale Fehler verschiedener Ordnungen. Weitere Quadrupolelemente können aber auch dazu dienen, den für die Erfindung erforderlichen Strahlenverlauf durch mehr als die beschriebenen fünf Quadrupolfelder zu bewirken.

Der einfachsymmetrische Aufbau bezweckt die Erzeugung einer einzigen anamorphotischen Abbildung, die dann zweckmäßigerweise zur Erzeugung einer relativen Phasenschiebung von näherungsweise 90° durch ein magnetisches oder elektrisches Feld mittels eines phasenschiebenden Elements dient. Natürlich kann, wie bereits erwähnt, bei bestimmten Objekten auch eine abweichende Phasenschiebung vorgesehen sein. Auch kann es zweckmäßig sein, die Vorrichtung durch die Veränderung des Feldes des phasenschiebenden Elements in einen bestimmten Bereich, meistens im Bereich von 90°, einzustellen, um objektabhängig den jeweils optimalen Kontrast zu erzeugen.

Eine Weiterbildung der vorbeschriebenen Vorrichtung sieht vor, daß ihr auf der optischen Achse eine zweite Vorrichtung nachgeordnet ist, deren Quadrupolelemente den Quadrupolelementen der ersten Vorrichtung entsprechen, deren Felder jedoch umgekehrt gepolt sind, so daß die anamorphotische Abbildung gegenüber der anamorphotischen Abbildung der ersten Vorrichtung um 90° gedreht ist. Weiterhin ist erforderlich, daß diese Vorrichtung im Strahlengang des Projektivlinsensystems des Elektronenmikroskops derart anordenbar ausgebildet ist, daß das Zwischenbild vor dem ersten Quadrupolelement liegt und die beiden genannten Vorrichtungen derart zu einer Vorrichtung zusammengefügt sind, daß in der durch diese Zusammenfügung entstehenden zentralen Symmetrieebene ein weiteres Zwischenbild der Vergrößerung M gebildet wird. Es wird dann das phasenschiebende Element der zweiten Vorrichtung derart ebenfalls um 90° gedreht angeordnet, so daß sie magnetische oder elektrische Felder zur relativen Phasenschiebung zwischen dem Bereich des Elektronenstrahls nullter Beugungsordnung und den Elektronenstrahlen höherer Beugungsordnungen dieser zweiten anamorphotischen Abbildung bereitstellt.

Diese Vorrichtung weist dann durch Hintereinanderschaltung einer ersten und einer zweiten Vorrichtung eine Verdopplung der vorbeschriebenen Vorrichtung auf, wobei zwischen den Vorrichtungen bezüglich der Elementenanordnung eine Symmetrieebene liegt. Dabei sind jedoch die Felder der zweiten Vorrichtung gegenüber der ersten umgekehrt gepolt, so daß es dazu kommt, daß die Axialstrahlen und die Feldstrahlen den x-Schnitt der zweiten Vorrichtung so durchlaufen wie den y-Schnitt der ersten Vorrichtung und den y-Schnitt der zweiten Vorrichtung wie den x-Schnitt der ersten Vorrichtung. Aus dem doppelsymmetrischen Aufbau ergibt sich somit ein antisymmetrischer Strahlenverlauf, der an der Ausgangsseite nach dem letzten Quadrupolelement ein drittes Zwischenbild erzeugt. Hier wird ein guter Phasenkontrast in der Regel dadurch erzielt, daß die auf die beiden anamorphotischen Abbildungen wirkenden phasenschiebenden Elemente elektrische oder magnetische Felder aufweisen, welche eine Phasenschiebung von jeweils näherungsweise 45° bewirken. Selbstverständlich kann es hier für bestimmte Objekte Abweichungen geben, die zu einem noch besseren Kontrast führen.

Die zweite vorbeschriebene Vorrichtung funktioniert im Prinzip in derselben Weise. Im Unterschied zur vorbeschriebenen Vorrichtung besitzt sie jedoch keine Doppelsymmetrie, da auf das der ersten Beugungszwischenbildebene nachgeordnete Quadrupolelement unmittelbar das der zweiten Beugungszwischenbildebene vorgeordnete Quadrupolelement folgt. Geht man also von der zuvor erörterten Vorrichtung aus, so besteht beispielsweise gegenüber der Zusammenfügung von zwei Vorrichtungen mit jeweils fünf Quadrupolelementen die Vereinfachung darin, daß bei der ersten Vorrichtung das fünfte Quadrupolelement und bei der zweiten Vorrichtung das erste Quadrupolelement weggelassen sind.

Eine solche von der Doppelsymmetrie abweichende Vorrichtung funktioniert dadurch, daß die Steigungen der Strahlen, die das der ersten Beugungsebene nachgeordnete Quadrupolelement verlassen, der Steigung entspricht, mit der sie in das Quadrupolelement eintreten müssen, das der zweiten Beugungsebene vorgeordnet ist. Da die beiden zusammengefügten Teilvorrichtungen durch die Weglassung der genannten zwei Quadrupolelemente jedoch in sich nicht mehr symmetrisch sind, kommt es zu einer Abweichung in den Steigungen der Strahlen, die einer Korrekturmaßnahme bedarf, welche darin besteht, daß die Felder der vor und nach der Beugungs- Zwischenbildebene liegenden Quadrupolelemente derart voneinander abweichend einstellbar sind, daß die Axialstrahlen in der zentralen Symmetrieebene ein weiteres Zwischenbild der Vergrößerung M bilden und die Feldstrahlen sich schneiden. Da jedoch die Gesamtsymmetrie bezüglich der zentralen Symmetrieebene gewahrt sein muß, müssen die entsprechenden Quadrupolfelder des zweiten Vorrichtungsteils in derselben Weise geregelt werden. Entweder es erfolgt eine simultane Einstellung der Feldstärken - natürlich mit der umgekehrten Polung - oder auch diese werden ergebnisorientiert derart eingestellt, daß am Ende der Vorrichtung ein drittes Zwischenbild der Größe M entsteht. Im Prinzip muß dies identisch sein, durch die letztgenannte Vorgehensweise könnten jedoch zusätzlich Fehler aufgrund von Produktionsungenauigkeiten ausgeglichen werden.

Dies gilt natürlich in entsprechender Weise auch für die Zusammenfügung von zwei entsprechenden Vorrichtungen mit mehr als fünf Quadrupolelementen, von denen entsprechende Quadrupolelemente weggelassen sind und daher an der Zusammenfügungsstelle nur das der ersten Beugungs- Zwischenbildebene nachgeordnete und das der zweiten Beugungs- Zwischenbildebene nachgeordnete Element übrigbleiben.

Insofern beinhaltet die vorgenannte Vorrichtung, wie auch die weiteren Vorrichtungen und Verfahren, nur die für die Erfindung funktionsnotwendigen Quadrupolelemente oder -felder. Sind weitere Quadrupolelemente oder Mehrpolelemente bzw. -felder zusätzlich angeordnet, beispielsweise um eine zusätzliche Farbfehler- oder andere Fehlerkorrektur zu erzielen, so sind diese wegen einer abweichenden Funktionalität, die zur erfindungsgemäßen Funktionalität lediglich eine additive Hinzufügung darstellt, für die Beurteilung der Erfindung unbeachtlich.

Bezüglich aller Vorrichtungen können natürlich die Strahlengänge statt durch fünf Quadrupolelemente für eine einfachsymmetrische Vorrichtung oder zehn Quadrupolelemente für eine doppelsymmetrische Vorrichtung auf mehrere weitere Quadrupolelemente verteilt werden. Wenn jedoch so die Wirkung eines der Quadrupolfelder beispielsweise auf zwei Felder verteilt wird, entspricht dies immer noch der erfindungswesentlichen Wirkungsweise des Feldes, beziehungsweise des entsprechenden erfindungsgemäßen Quadrupolelements. In entsprechender Weise gilt dies auch für die Vorrichtung, die von der Doppelsymmetrie dadurch abweicht, daß bei der Zusammenfügung zweier Einzelvorrichtungen Quadrupolelemente weggelassen werden, wenn diese Weglassung unter Beibehaltung der Antisymmetrie des Strahlengangs erfolgt. Wie bei den doppelsymmetrischen Vorrichtungen werden auch bei Vorrichtungen, bei denen gegenüber der Doppelsymmetrie Quadrupolelemente weggelassen wurden, in jeder Beugungs- Zwischenbildebene phasenschiebende Elemente mit magnetischen oder elektrischen Feldern angeordnet, wobei diese vorzugsweise eine Phasenschiebung von jeweils näherungsweise 45° bewirken.

Entsprechend dem Verfahren ist auch bei den Vorrichtungen vorzugsweise vorgesehen, daß die Quadrupole zur Erzeugung und Kompensation der mindestens einen anamorphotischen Abbildung eine derartige Ausdehnung in Richtung der optischen Achse aufweisen und für eine derartige Felderzeugung ausgebildet sind, daß eine Erzeugung eines astigmatischen Zwischenbildes in ihrem Wirkungsbereich möglich ist. Auch hier ist die Feldstärke so zu wählen, daß die axiale Ausdehnung der Quadrupole nur zu einer Ausdehnung der Bauhöhe der Vorrichtung führt, die noch im Rahmen einer guten Einbaubarkeit in ein Elektronenmikroskop liegt.

Für das phasenschiebende Element ist es wesentlich, daß sein Feld unabhängig davon, ob es sich um ein magnetisches oder elektrisches Feld handelt, eine relative Phasenschiebung zwischen den Strahlen des Bereichs des Elektronenstrahls nullter Beugungsordnung und den Elektronenstrahlen höherer Beugungsordnungen bewirkt. Unter dieser Prämisse könnte das Feld natürlich auch auf beide Arten von Strahlen einwirken, zweckmäßigerweise ist das phasenschiebende Element jedoch derart ausgebildet, daß das magnetische oder elektrische Feld entweder im Bereich des Nullstrahls applizierbar ist und der Bereich der gebeugten Strahlen auf Nullpotential liegt oder umgekehrt.

Konkrete Ausgestaltungen derartiger phasenschiebender Elemente sind im Stand der Technik bekannt, beispielhaft werden hier zwei Möglichkeiten beschrieben:

Eine Ausgestaltungsmöglichkeit eines phasenschiebenden Elements für die Applikation eines Feldes im Bereich des Nullstrahls besteht darin, daß das phasenschiebende Element zur Erzeugung eines elektrischen Feldes als abgeschirmter Leiter ausgebildet ist, der von einer Befestigung an der Gehäusewand ausgehend in der Beugungs- Zwischenbildebene im Wesentlichen radial in Richtung des Bereichs des Nullstrahls erstreckend angeordnet ist, wobei der abgeschirmte Leiter vor dem Bereich des Nullstrahls ein derart positioniertes Ende aufweist, daß zwischen dem Leiter und der ihn umgebenden Abschirmung ein elektrisches Feld gebildet wird, das diesen Bereich des Nullstrahls erfaßt.

Ein anderes Beispiel für ein phasenschiebendes Element, bei dem der Bereich des Nullstrahls auf Nullpotential liegt und das Feld im Bereich der gebeugten Strahlen applizierbar ist, kann vorsehen, daß das phasenschiebende Element zur Erzeugung eines elektrischen Feldes einen Schlitz aufweist, der die anamorphotische Abbildung einschließt, wobei sich beidseitig entlang des Schlitzes Elektroden für die Applikation des elektrischen Feldes erstrecken, die für den Bereich des Nullstrahls im Bereich der optischen Achse durch je einen auf Nullpotential liegenden Leiter unterbrochen sind.

Bei diesem phasenschiebenden Element kommt es darauf an, daß die anamorphotische Abbildung mit ihren Längsseiten möglichst dicht an den Schlitz heranreicht, ohne diesen jedoch zu berühren. Deshalb ist es zweckmäßig, wenn die Vorrichtung derart eingerichtet ist, daß die Quadrupolelemente vor und nach der Beugungs- Zwischenbildebene derartige Felder erzeugen, daß die Breite der anamorphotischen Abbildung gerade noch in die Breite des Schlitzes hineinpaßt. Auf diese Weise wird eine gleichmäßige und zielgerichtete Applikation des Feldes auf die gebeugten Strahlen erreicht.

Das Ziel der Erfindung wird am besten dadurch erreicht, daß mit den Quadrupolen derartige Feldstärken erzeugbar sind und daß die Anordnung der Vorrichtung an einer derartigen Stelle des Strahlengangs des Projektivlinsensystems eines Elektronenmikroskops vornehmbar ist, daß die Vergrößerung M des Zwischenbildes eine derartige

Steigung $\dfrac{1}{M}$ der Axialstrahlen ergibt, daß das Aspektverhältnis der mindestens einen anamorphotischen Abbildung größer als 100 ist. Für höhere Anforderungen bezüglich der Kontrastbildung, insbesondere bei einer hohen Auflösung und starken Vergrößerungen, sollte das Aspektverhältnis durch die vorgenannte Anordnung und Feldstärken größer als 200 sein.

Die Erfindung wird nachfolgend anhand von Prinzipskizzen erläutert. Es zeigen

**Fig. 1**      eine Prinzipskizze zur Veranschaulichung der erfinderischen Idee,
**Fig. 2**      eine schematische Darstellung eines einfachen Aufbaus einer erfindungsgemäßen Vorrichtung,
**Fig. 2a**    deren Strahlenverlauf im x-Schnitt,
**Fig. 2b**    deren Strahlenverlauf im y-Schnitt,
**Fig. 3**      eine schematische Darstellung eines doppelsymmetrischen Aufbaus einer erfindungsgemäßen Vorrichtung,
**Fig. 4**      eine schematische Darstellung einer erfindungsgemäßen Vorrichtung, bei der gegenüber der Doppelsymmetrie zwei Quadrupole weggelassen sind,
**Fig. 5**      eine schematische Darstellung eines Elektronenmikroskops mit einer eingebauten erfindungsgemäßen Vorrichtung,
**Fig. 6**      ein Ausführungsbeispiel eines phasenschiebenden Elements zur Beeinflussung des Bereichs des Nullstrahls,
**Fig. 6a**    den Potentialverlauf des Feldes dieses phasenschiebenden Elements,
**Fig. 7**      ein Ausführungsbeispiel eines phasenschiebenden Elements zur Beeinflussung der gebeugten Strahlen,
**Fig. 7a**    einen Schnitt A-B durch das phasenschiebende Element gemäß Fig. 7 und
**Fig. 7b**    den Potentialverlauf des Feldes dieses phasenschiebenden Elements.

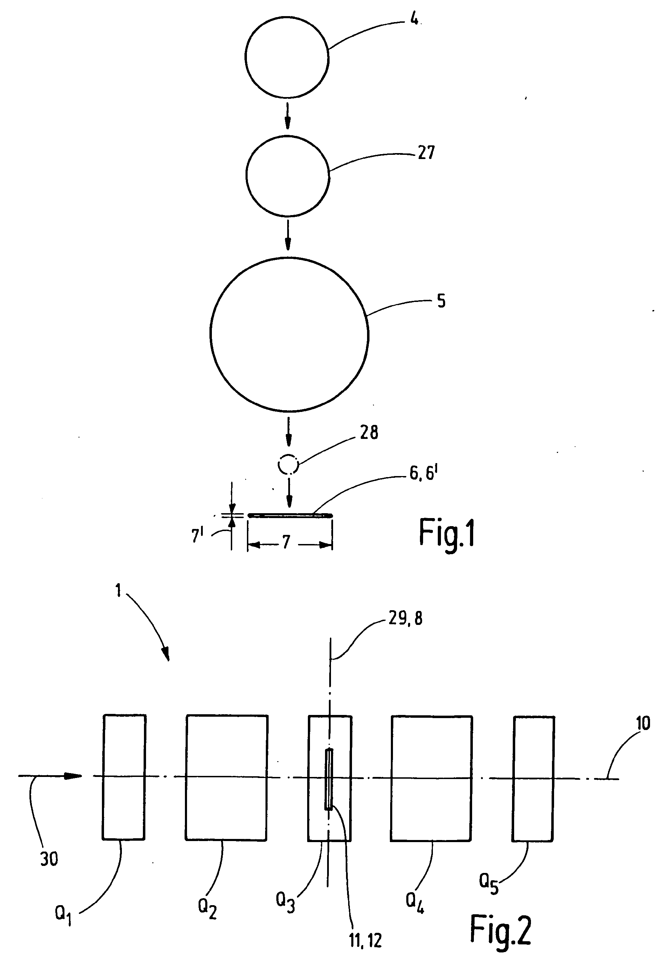

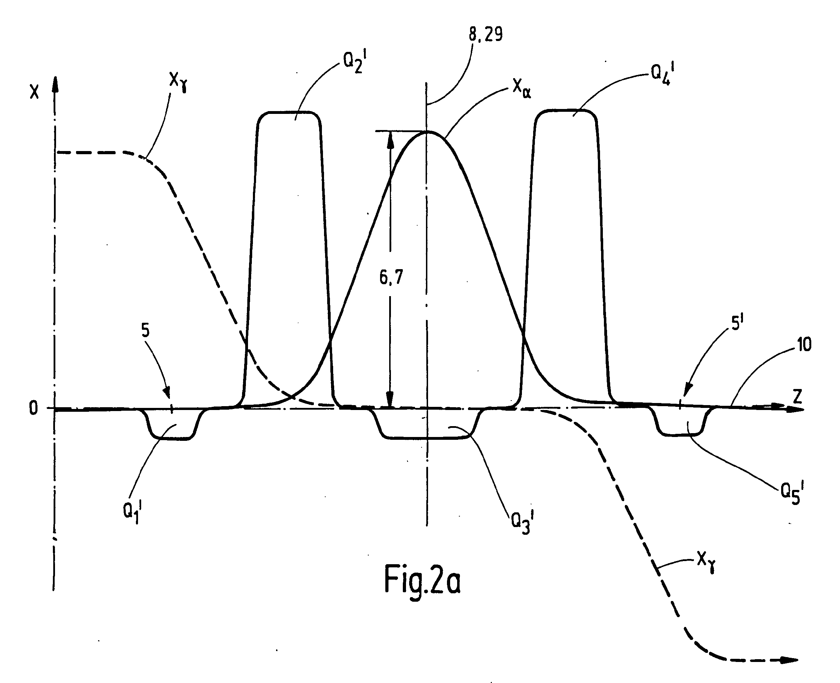

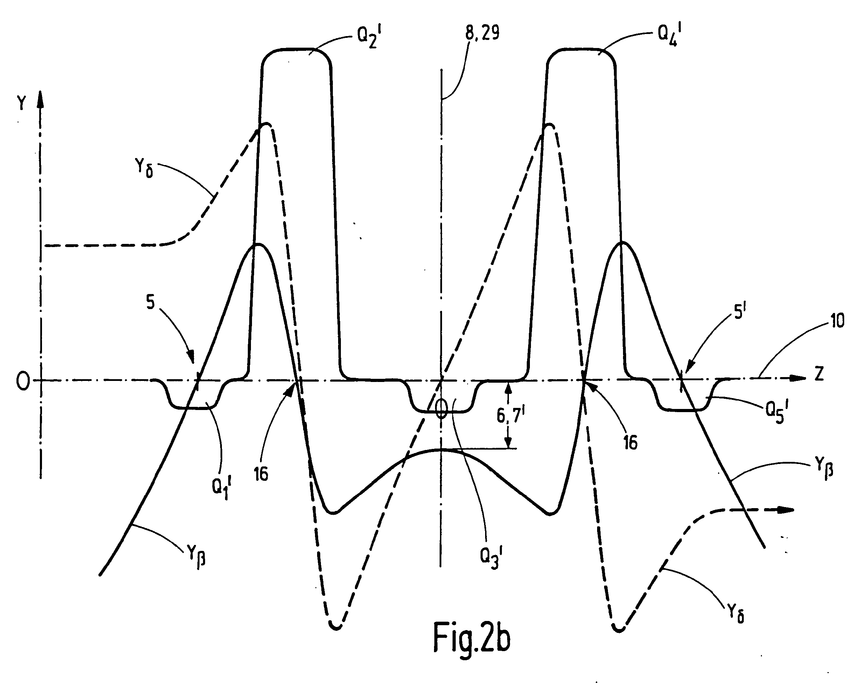

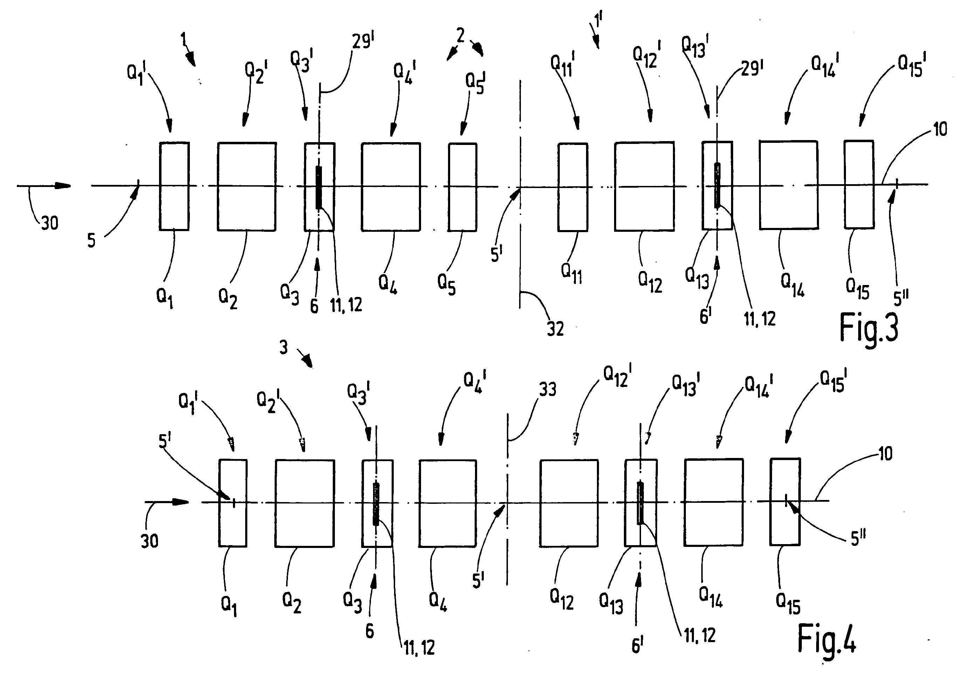

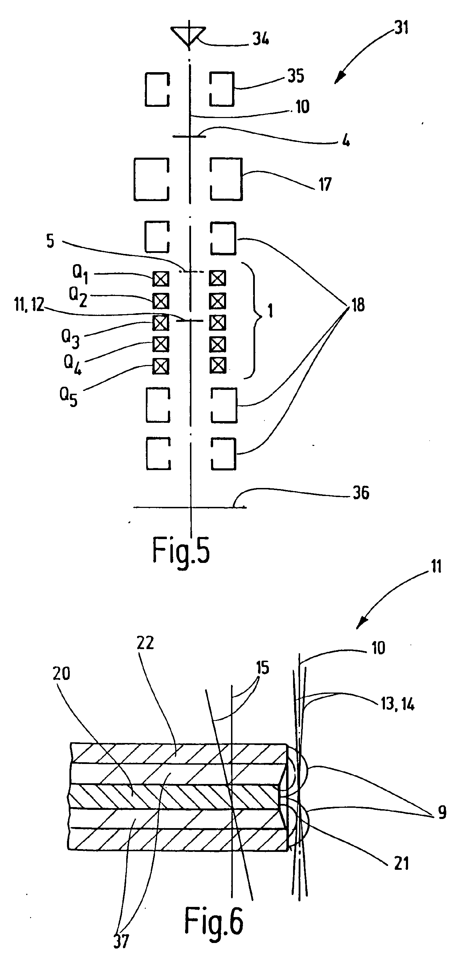

Fig. 1 zeigt eine Prinzipskizze zur Veranschaulichung der erfinderischen Idee. Bezüglich des technischen Hintergrunds wird hier auf die Darstellung des Strahlengangs in einem Elektronenmikroskop bei Prof. Rose (a.a.O, S. 85, Fig. 4.9) verwiesen. Dort ist dargestellt, wie sich nach dem Objekt im Strahlengang Zwischenbilder und Beugungsbilder abwechseln (Rose, a.a.O., S. 79 "theorem of alternating images"). Die vorgenannte Darstellung des Elektronenmikroskops ist insofern vereinfacht, daß regelmäßig nicht nur eine Projektivlinse, sondern ein ganzen Projektivlinsensystem 18 (Fig. 5) vorhanden ist, so daß weitere Zwischen- und Beugungsbilder entstehen. Dabei entstehen die Zwischenbilder, wenn die axialen Strahlen Xo. und $y_\beta$ als Abbildung des Objekts durch Null gehen und die Beugungsbilder entstehen, wenn die außeraxialen Strahlen $_\chi y$ und ys als Abbildung der Strahlenquelle durch Null gehen (Fig. 2a und Fig. 2b). Diese Anzahl von Zwischenbildern steht zur Verfügung, um ein Zwischenbild 27 der Vergrößerung M auszuwählen, welche zur Erzielung des gewünschten Aspektverhältnisses benötigt wird.

In Fig. 1 wird in einer schematischen Vereinfachung gezeigt, wie von einem Objekt 4 in einem Elektronenmikroskop 31 zwischen einem Objektiv 17 und einer der erfindungsgemäßen Vorrichtungen 1, 2 oder 3 ein Beugungs-Zwischenbild 27 und im Eingangsbereich der Vorrichtungen 1, 2 oder 3 ein Zwischenbild 5 gebildet wird, welches das Objekt 4 M-fach vergrößert. Die dargestellte Vergrößerung M ist dabei nur symbolisch, tatsächlich ist M wesentlich größer als gezeichnet, um eine geringe Steigung

$$\frac{1}{M}$$

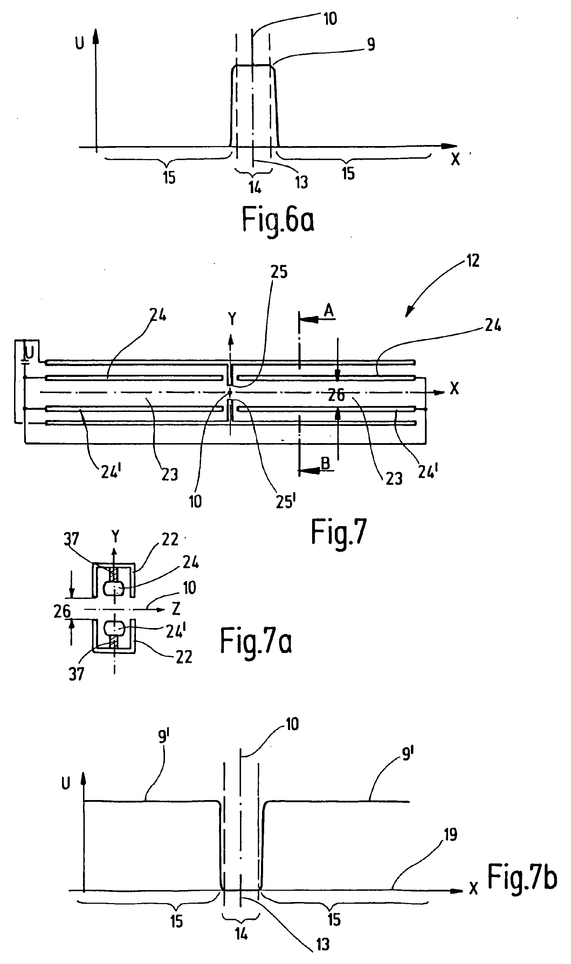

zu erzielen, welche zu einem stark verkleinerten Beugungsbild 28 führt, das die Grundlage für eine Verkleinerung der anamorphotischen Abbildung 6, 6' ist. Dieses Beugungsbild 28 ist jedoch in der Regel ein virtuelles Beugungsbild 28, da die Vorrichtung 1, 2 oder 3 vor der Bildung desselben in den Strahlengang mit der Steigung

$$\frac{1}{M}$$

eingreift, um die anamorphotische Abbildung 6, 6' zu bilden. Das virtuelle Beugungsbild 28 steht somit im umgekehrten Verhältnis zur Vergrößerung M des Zwischenbildes 5. Es kann also durch eine starke Vergrößerung M ein entsprechend verkleinertes Beugungsbild 28 bzw., da dies virtuell ist, eine entsprechend geringe Steigung $\frac{1}{M}$ erzielt werden, um erfindungsgemäß eine ebenfalls entsprechend verkleinerte anamorphotische Abbildung 6, 6' zu erzielen, die trotz eines großen Aspektverhältnisses von mindestens 100 eine Länge 7 aufweist, die derart begrenzt ist, daß keine Fehler entstehen, welche die Bildqualität verschlechtern. Bei der anamorphotischen Abbildung 6 handelt es sich dabei um ein Beugungsbild, da $x_\gamma$ und $y_\delta$ Null sind (Fig. 2a und 2b). Dieses ist jedoch durch die Einwirkung der Quadrupolfelder verzerrt, also entsprechend der Anamorphie der Abbildung 6 derart auseinandergezogen, daß sich im Bereich der Mitte der Länge 7 der Nullstrahl 13 befindet und jeweils nach außen die Elektronenstrahlen 15 höherer Beugungsordnungen aufgereiht sind und zwar mit zunehmender Beugungsordnung weiter außen.

Das Aspektverhältnis ist dabei das Verhältnis der Länge 7 der anamorphotischen Abbildung 6 zu dessen Breite 7'. Das auf diese Weise erzielte große Aspektverhältnis $\frac{7}{7'} \geq 100$ ist dann Grundlage für eine möglichst optimale Trennung des Bereichs 14 des Nullstrahls 13 von den Elektronenstrahlen höherer Beugungsordnungen 15 (Fig. 6a und 7b), wodurch ein besserer Phasenkontrast erzielbar ist. Die Wahl der Vergrößerung M des Zwischenbildes 5 sollte derart erfolgen, daß zur Erzielung eines Aspektverhältnisses von mindestens 100 das virtuelle Beugungszwischenbild 28 eine mindestens 20-fache Verkleinerung gegenüber einem unvergrößerten Zwischenbild als Ausgangspunkt darstellt. Um diese Vergrößerung M des Zwischenbildes 5 zu erzielen, muß die Vorrichtung an eine entsprechende Stelle des Projektivlinsensystems 18 eines Elektronenmikroskops 31 eingebaut werden, an der ein solches Zwischenbild 5 der Vergrößerung M gebildet ist (siehe Fig. 5). Da das Projektivlinsensystem 18 - oft auch als Zwischenlinsen (mehrere) und Projektionslinse (die letzte Linse) bezeichnet - in der Regel so viele Linsen mit Zwischenbildern umfaßt, daß eine entsprechende Vergrößerung M eines Zwischenbildes 5 auswählbar ist, bedarf es hier keiner detaillierten Beschreibung von Strahlengang und Linsen, um den Einbauort für die Vorrichtung 1, 2, 3 zu ermitteln. Dies ist vom Gerätetyp abhängig, wobei jede der Vorrichtungen 1, 2, 3 der Erfindung für den Strahlengang und das Strahlrohr jedes Bautyps eines Elektronenmikroskops angepaßt werden muß.

Fig. 2 zeigt eine schematische Darstellung eines einfachen Aufbaus einer erfindungsgemäßen Vorrichtung 1. Diese besteht aus zwei eingangsseitigen Quadrupolelementen $Q_1$ und $Q_2$, einem zentralen Quadrupolelement $Q_3$, dessen Mitte eine Symmetrieebene 29 bildet und zwei ausgangsseitigen Quadrupolelementen $Q_4$ und $Q_5$, wobei das Quadrupolelement $Q_4$ dem Quadrupolelement $Q_2$ und das Quadrupolelement $Q_5$ dem Quadrupolelement $Q_1$ entspricht. In der Symmetrieebene 29 ist das phasenschiebende Element 11 oder 12, das verschiedene Ausgestaltungen aufweisen kann, angeordnet. Weiterhin ist noch die optische Achse 10 und der Strahlenverlauf 30 eingezeichnet.

Fig. 2a zeigt den Strahlenverlauf der Vorrichtung 1 gemäß Fig. 2 im x-Schnitt. Entlang der z-Achse, in der die optische Achse 10 liegt, sind die Quadrupolfelder $Q_1'$, $Q_2'$, $Q_3'$, $Q_4'$, $Q_5'$ der Quadrupolelemente $Q_1$, $Q_2$, $Q_3$, $Q_4$, $Q_5$ eingezeichnet, wobei ersichtlich ist, daß sich in der Mitte des Quadrupolfeldes $Q_3'$ die Symmetrieebene 29 befindet. Diese Symmetrieebene 29 ist die Beugungszwischenbildebene 8, in der sich auch das phasenschiebende Element 11 oder 12 befindet. Die Quadrupolfelder $Q_2'$ und $Q_4'$, die der Beugungszwischenbildebene 8 vor- und nachgeordnet sind, sind von gleicher Stärke und so stark, daß sie, ohne die Bauhöhe allzusehr zu vergrößern, eine Ausdehnung in Richtung der optischen Achse 10 aufweisen, wie sie oben definiert wurde. Auch das eingangsseitige und das ausgangsseitige Quadrupolfeld $Q_1'$ und $Q_5'$ sind gleich stark und symmetrisch zur Symmetrieebene 29. Dabei sind sie und das Quadrupolfeld $Q_3'$ umgekehrt gepolt als die Quadrupolfelder $Q_2'$ und $Q_4'$.

Fig. 2b zeigt denselben Strahlenverlauf mit denselben Quadrupolfeldern $Q_1'$, $Q_2'$, $Q_3'$, $Q_4'$, $Q_5'$ im y-Schnitt.

In die Schnitte x und y sind die Axialstrahlen $x_\alpha$ und $y_\beta$ und die Feldstrahlen $x_\gamma$ und $y_\delta$ als Fundamentalstrahlen eingezeichnet. Um den Verlauf dieser Strahlen $x_\alpha$, $y_\beta$, $x_\gamma$, $y_\delta$ besser einzeichnen zu können, sind jedoch unterschiedliche Maßstäbe bezüglich der x- bzw. y-Achse gewählt, insbesondere weil der $x_\alpha$-Strahl im Verhältnis zum $y_\beta$-Strahl eine derart weite Auslenkung erfährt, daß bei gleichem Maßstab entweder die Auslenkung des $y_\beta$-Strahls gar nicht mehr sichtbar wäre oder der $x_\alpha$-Strahl im Beriech der Symmetrieebene 29 weit außerhalb des Blattes verlaufen würde. Aus diesem Grund sind auch die x- und y-Achse nicht mit einer Maßeinheit versehen.

Die Vorrichtung 1 ist, wie oben aufgeführt, in den Strahlengang des Projektivlinsensystems 18 eines Elektronenmikroskops 31 eingefügt (siehe Fig. 5), daß in ihrem Eingangsbereich ein Zwischenbild 5 mit einer M-fachen Vergrößerung des Objekts 4 liegt (Fig. 1). Da in der Darstellung der Figuren 2a und 2b die $x_\alpha$- und $y_\beta$-Strahlen die optische Achse im Quadrupolfeld $Q_1'$ schneiden, liegt dort das Zwischenbild 5. Dies ist jedoch keine notwendige Lage des Zwischenbildes 5, es könnte auch vor oder nach dem Quadrupolfeld $Q_1'$ liegen, vorzugsweise jedoch davor. Wesentlich ist dabei, daß die Quadrupolfelder $Q_1'$, $Q_2'$, $Q_3'$, $Q_4'$, $Q_5'$ derart mit dem Strahlengang des Elektronenmikroskops 31 abgestimmt sind, daß sich in der Symmetrieebene 29 eine Beugungs-Zwischenbildebene 8 mit einem Beugungszwischenbild befindet, dort also $x_\gamma$ und $y_\delta$ Null sind. Dort ist auch eine anamorphotische Abbildung 6 der Axialstrahlen $x_\alpha$ und $y_\beta$.

Vorzugsweise weisen die Quadrupole $Q_2$, $Q_4$, $Q_{12}$, $Q_{14}$ zur Erzeugung und Kompensation der mindestens einen anamorphotischen Abbildung 6, 6' eine derartige Ausdehnung in Richtung der optischen Achse 10 auf und sind für eine derartige Felderzeugung $Q_2'$, $Q_4'$, $Q_{12}'$, $Q_{14}'$ ausgebildet, daß ein astigmatisches Zwischenbild 16 in ihrem Wirkungsbereich erzeugbar ist. Dadurch wird erreicht, daß sich die axiale Feldausdehnung unter Einhaltung einer akzeptablen Bauhöhe in das optische System eines Elektronenmikroskops 31 einfügen läßt.

Wesentlich für die Erzeugung der anamorphotischen Abbildung 6 und deren Kompensation sind die Quadrupolfelder $Q_2'$, $Q_4'$, welche hier zur Begrenzung der axialen Ausdehnung entsprechend stark eingezeichnet sind. Sie dienen dazu, ein Aspektverhältnis von mindestens 100 zu erzeugen, was übertragen auf die Darstellung bedeutet, daß die in Fig. 2a eingezeichnete Länge 7 der anamorphotischen Abbildung 6 mindestens 100 mal so groß sein muß wie die in Fig. 2b eingezeichnete Breite 7'. Um das darstellen zu können, wurden auch die sehr unterschiedlichen Maßstäbe gewählt. Will man also den Strahl $y_\beta$ mit dem Strahl $x_\alpha$ vergleichen, müßte die Länge 7 der anamorphotischen Abbildung 6 mindestens die 100-fache Ausdehnung in Richtung der x-Achse aufweisen als deren Breite 7' in Richtung der y-Achse.

In der Beugungszwischenbildebene 8 befinden sich die phasenschiebenden Elemente 11 oder 12 mit ihren Feldern 9, 9'. Diese sind bei den Darstellungen der Figuren 2a und 2b nicht eingezeichnet, da sie keinen Einfluß auf die Verläufe der Axialstrahlen $x_\alpha$, $y_\beta$ und der Feldstrahlen $x_\gamma$, $y_\delta$ haben.

**Fig. 3** zeigt eine schematische Darstellung eines doppelsymmetrischen Aufbaus einer erfindungsgemäßen Vorrichtung 2. Dabei entspricht der erste Teil der in Fig. 2 gezeichneten Vorrichtung 1, welche danach als Vorrichtung 1' nochmals angeordnet ist. Deren Quadrupolelemente $Q_{11}$, $Q_{12}$, $Q_{13}$, $Q_{14}$, $Q_{15}$ entsprechen den Quadrupolelementen $Q_1$, $Q_2$, $Q_3$, $Q_4$, $Q_5$ der Vorrichtung 1, sie sind gleich angeordnet, so daß sich jeweils eine Symmetrieebene 29' der Vorrichtungen 1 und 1' ergibt sowie die Symmetrie der Vorrichtung 2 durch die zentrale Symmetrieebene 32. In den zwei Symmetrieebenen 29' sind jeweils phasenschiebende Elemente 11 oder 12 angeordnet, um Phasenschiebungen in den anamorphotischen Abbildungen 6 und 6' zu bewirken.

Bezüglich der Quadrupolfelder $Q_{11}'$, $Q_{12}'$, $Q_{13}'$, $Q_{14}'$, $Q_{15}'$ der Vorrichtung 1' stellt die Symmetrieebene 32 allerdings eine Ebene der Antisymmetrie dar, da diese im Vergleich zu den Feldern $Q_1'$, $Q_2'$, $Q_3'$, $Q_4'$, $Q_5'$ der Vorrichtung 1 umgekehrt gepolt sind (bzw. um 90° gedreht, was dasselbe ist).

Im Unterschied zur Vorrichtung 1 gem. Fig. 2 muß bei der doppelsymmetrischen Vorrichtung 2 das Zwischenbild 5 vor dem erste Quadrupolelement $Q_1$ liegen, da es nur dadurch möglich ist, ein weiteres Zwischenbild 5' der Vergrößerung M in der hinter dem Quadrupolelement $Q_5$ liegenden zentralen Symmetrieebene 32 zu erzeugen. Dies ist für den antisymmetrischen Verlauf der Fundamentalbahnen, also der Axialstrahlen $x_\alpha$, $y_\beta$ und der Feldstrahlen $x_\gamma$, $x_\delta$ erforderlich. Dieser Strahlenverlauf erzeugt dann nach dem letzten Quadrupolelement $Q_{15}$ des zweiten Teils 1' der Vorrichtung 2 noch ein drittes Zwischenbild 5" der Vergrößerung M.

Der Verlauf der Fundamentalbahnen wird unter Hinweis auf die Abweichungen anhand der Fig. 2a und 2b erläutert. Ein Unterschied besteht zunächst darin, daß die Axialstrahlen $x_\alpha$, $y_\beta$ derart in die Bilder (Fig. 2a, 2b) einlaufen müssen, daß sie vor dem ersten Quadrupolfeld $Q_1'$ Null sind, so daß das Zwischenbild 5, wie eben erwähnt, vor dem ersten Quadrupolelement $Q_1$ liegt und damit das weitere Zwischenbild 5' hinter dem Quadrupolelement Q5 in der zentralen Symmetrieebene 32 liegen kann.

Die Fig. 2a und 2b zeigen somit - unter Beachtung des o. g. Unterschieds - die Verläufe der Fundamentalbahnen im ersten Vorrichtungsteil 1 der Vorrichtung 2. Im zweiten Vorrichtungsteil 1' nimmt der Axialstrahl $x_\alpha$ im x-Schnitt (Fig. 2a) einen Verlauf, der dem Axialstrahl $y_\beta$ des y-Schnitts (Fig. 2b) entspricht, jedoch um 180° um die z-Achse gedreht ist. Wegen der unterschiedlichen Maßstäbe ist dabei die negative Steigung des Axialstrahls $x_\alpha$ beim Austritt aus der Fig. 2a identisch mit der negativen Steigung von $y_\beta$ beim Eintritt in die Fig. 2b, wenn man sich $y_\beta$ um 180° um die z-Achse gedreht vorstellt.

Umgekehrt muß man sich für die Vorrichtung 2 mit dem doppelsymmetrischen Aufbau den weiteren Verlauf der Axialbahn $y_\beta$ nach der Darstellung des y-Schnitts in Fig. 2b so vorstellen, daß sie sich entsprechend der Axialbahn $x_\alpha$ der Fig. 2a, aber um 180° um die z-Achse gedreht, fortsetzt, auch hier unter Beachtung des Maßstabsunterschiedes. Der gleiche Rollentausch findet in entsprechender Weise bezüglich der Feldstrahlen $x_\gamma$ und $y_\delta$ statt, wobei auch dort Maßstabsunterschiede zu beachten sind, die allerdings wesentlich geringer sind.

Auf eine gesonderte Darstellung dieser Fundamentalbahnverläufe der doppelsymmetrischen Vorrichtung 2 wurde deshalb verzichtet, weil gleiche Maßstäbe entweder die Strahlen, welche die Breiten 7' der anamorphotischen Abbildungen 6 und 6' bestimmen - das ist bei der Vorrichtung 1 der Axialstrahl $y_\beta$ und bei der Vorrichtung 1' der Axialstrahl $x_\alpha$ - sich zeichnerisch nicht mehr erkennbar von der z-Achse entfernen würden oder die Strahlen, welche die Länge 7 der anamorphotischen Abbildungen 6 und 6' bestimmen - das ist bei der Vorrichtung 1 der Axialstrahl $x_\alpha$ und bei der Vorrichtung 1' der Axialstrahl $y_\beta$ - im zur Verfügung stehenden Raum nicht darstellbar wäre.

**Fig. 4** zeigt eine schematische Darstellung einer erfindungsgemäßen Vorrichtung 3, bei der gegenüber der Vorrichtung 2 mit doppelsymmetrischem Aufbau (Fig. 3) die zwei Quadrupolelemente $Q_5$ und $Q_{11}$ weggelassen sind, so daß nur noch der erste Vorrichtungsteil mit den Quadrupolelementen $Q_1$, $Q_2$, $Q_3$ und $Q_4$ bezüglich der Symmetrieebene 33 zum zweiten Vorrichtungsteil mit den Quadrupolelementen $Q_{12}$, $Q_{13}$, $Q_{14}$, $Q_{15}$ symmetrisch ist. Es gibt also keine Doppelsymmetrie. Auch hier sind die Qadrupolfelder $Q_{12}'$, $Q_{13}'$, $Q_{14}'$, $Q_{15}'$ des zweiten Vorrichtungsteils gegenüber den Quadrupolfeldern $Q_1'$, $Q_2'$, $Q_3'$, $Q_4'$ des ersten Vorrichtungsteils umgekehrt gepolt und es muß ein weiteres Zwischenbild 5' der Vergrößerung M in der Symmetrieebene 33 gebildet werden. Dazu muß jedoch das erste Zwischenbild 5 der Vergrößerung M nicht unbedingt vor dem ersten Quadrupolelement $Q_1$ liegen, es kann jedoch dort liegen. Es kann aber auch im Bereich des ersten Quadrupolelements $Q_1$ liegen, wie dies gezeichnet ist.

Der Fundamentalbahnverlauf entspricht der Beschreibung zur Vorrichtung 2 mit doppelsymmetrischem Aufbau mit dem Unterschied, daß der x-Schnitt (Fig. 2a) hinter dem Quadrupolfeld $Q_4$' unter Auslassung des Quadrupolfeldes $Q_5$' die Symmetrieebene 33 aufweist, die bezüglich der danach folgenden Quadrupolfelder $Q_{12}$', $Q_{13}$', $Q_{14}$', $Q_{15}$' - da diese umgekehrt gepolt sind - eine Antisymmetrieebene ist. Auch hinter dieser Symmetrieebene 33 ist in entsprechender Weise das Quadrupolfeld $Q_{11}$' weggelassen, so daß die Übergabe der Fundamentalbahnen der Axialstrahlen $x_\alpha$, $y_\beta$ und der Feldstrahlen $x_\gamma$, $y_\delta$ vom Quadrupolfeld $Q_4$' zum Quadrupolfeld $Q_{12}$' stattfindet. Auch hier setzt sich beispielsweise der Axialstrahl $x_\alpha$ des x-Schnitts (Fig. 2a) nach dem Feld $Q_4$' so fort, wie der Axialstrahl $y_\beta$ in Fig. 2b gezeichnet ist. Letzterer ist jedoch um 180° um die z-Achse gedreht und beginnt erst vor dem Quadrupolfeld $Q_{12}$', da das Quadrupolfeld $Q_{11}$' weggelassen ist. In derselben Weise findet auch bezüglich des Axialstrahls $y_\beta$ der Rollentausch unter Weglassung der Quadrupolfelder $Q_5$' und $Q_{11}$' statt, ebenso bezüglich der Feldstrahlen $x_\gamma$ und $y_\delta$. Für die Maßstäbe gilt das oben beschriebene entsprechend.

Da bei dieser Vorrichtung 3 jedoch die Doppelsymmetrie fehlt, sind die Kompensationseffekte der Quadrupolelemente unvollständig. Deshalb muß eine Korrektur vorgenommen werden, welche dazu führt, daß die Steigungen der Fundamentalbahnen $x_\alpha$, $y_\beta$, $x_\gamma$, $y_\delta$ bei der Übergabe vom Quadrupolfeld $Q_4$' an das Quadrupolfeld $Q_{12}$' so erfolgt, daß die Fundamentalbahnverläufe $x_\alpha$, $y_\beta$, $x_\gamma$, $y_\delta$ sich nach der Symmetrieebene 33 antisymmetrisch mit dem beschriebenen Rollentausch fortsetzen. Diese Korrektur wird dadurch bewirkt, daß die Quadrupolelemente $Q_2$' und $Q_4$' derart einstellbar sind, daß ihre Quadrupolfelder $Q_2$' und $Q_4$' Abweichungen in ihrer Stärke aufweisen. Diese Korrektur wird so lange in der einen oder anderen Richtung ($Q_2$' > $Q_4$' oder $Q_4$' > $Q_2$') vorgenommen, bis das weitere Zwischenbild 5' der Vergrößerung M exakt in der Symmetrieebene 33 liegt.

Da die Antisymmetrie der Quadrupolfelder $Q_1$', $Q_2$', $Q_3$', $Q_4$' und $Q_{12}$', $Q_{13}$', $Q_{14}$', $Q_{15}$' zur Symmetrieebene 33 jedoch gewahrt sein muß, sind auch die Quadrupolfelder $Q_{12}$' und $Q_{14}$' derart einzustellen, daß die Stärke des Quadrupolfeldes $Q_{12}$' der Stärke des Quadrupolfeldes $Q_4$' entspricht und die Stärke des Quadrupolfeldes $Q_{14}$' der Stärke des Quadrupolfeldes $Q_2$'. Die letztgenannte Korrektur läßt sich auch ergebnisorientiert dadurch vornehmen, daß die Quadrupolfelder $Q_{12}$' und $Q_{14}$' so lange in ihrem gegenseitigen Stärkeverhältnis verändert werden, bis das dritte Zwischenbild 5" bezüglich der Entfernung zur Symmetrieebene 33 und der Vergrößerung M zum Zwischenbild 5 symmetrisch ist. Dabei kann sich eine geringfügige Abweichung von der Antisymmetrie der Quadrupolfelder $Q_2$' und $Q_4$' zu $Q_{12}$' und $Q_{14}$' einstellen, um Produktionsungenauigkeiten der elektronenoptischen Bauelemente zu kompensieren.

Bei den beiden vorbeschriebenen Vorrichtungen 2 und 3 ist die zweite anamorphotische Abbildung 6' gegenüber der ersten anamorphotischen Abbildung 6 um 90° gedreht, so daß auch die Anordnung der phasenschiebenden Elemente 11, 12 entsprechend der jeweiligen Lage dieser anamorphotischen Abbildungen 6, 6' erfolgen muß.

**Fig. 5** zeigt eine schematische Darstellung eines Elektronenmikroskops 31 mit dem Einbau einer erfindungsgemäßen Vorrichtung, beispielhaft dargestellt an einer Vorrichtung 1. Das Elektronenmikroskop 31 weist entlang einer optischen Achse 10 eine Strahlenquelle 34, einen Kondensor 35, das Objekt 4, das Objektiv 17, ein Projektivlinsensystem 18 und eine Projektionsfläche 36 auf. Im Bereich des Projektivlinsensystems 18, das mehrere Einzellinsen aufweist - beispielhaft sind drei Linsen eingezeichnet - ist die Vorrichtung 1 angeordnet. In entsprechender Weise kann natürlich auch eine Vorrichtung 2 oder eine Vorrichtung 3 angeordnet sein. Für eine derartige Anordnung wird im Bereich des Projektivlinsensystems 18 ein Zwischenbild 5 der gewünschten Vergrößerung M ausgesucht und dann die Vorrichtung 1, 2 oder 3 derart angeordnet, daß die Lage des Zwischenbildes 5 zu diesen Vorrichtungen den Fig. 2a, 2b, 3 oder 4 entspricht.

**Fig. 6** zeigt ein Ausführungsbeispiel eines phasenschiebenden Elements 11 zur Beeinflussung des Bereichs 14 des Nullstrahls 13. Dieses phasenschiebende Element 11 erstreckt sich von der Gehäusewand der Strahlröhre des Elektronenmikroskops 31 bis kurz vor die optische Achse 10, und zwar derart, daß das Ende 21 eines abgeschirmten Leiters 20 ein elektrisches Feld 9 erzeugt, welches den Bereich 14 des Nullstrahls 13 erfaßt. Nicht erfaßt werden dabei die Elektronenstrahlen 15 höherer Beugungsordnungen. Das elektrische Feld 9 erstreckt sich dabei von dem Leiter 20 zu einer Abschirmung 22, die den Leiter 20 unter Einschluß eines Isolators 37 umgibt.

**Fig. 6a** zeigt den Potentialverlauf des Feldes 9 des phasenschiebenden Elementes 11. Aufgetragen ist das Potential U gegenüber der x-Achse, wobei ersichtlich ist, daß nur im Bereich 14 des Nullstrahls 13 ein elektrisches Feld 9 appliziert wird und in dem Bereich der Elektronenstrahlen 15 höherer Beugungsordnungen kein elektrisches Feld vorhanden ist. Auf diese Weise kann je nach den oben beschriebenen Ausführungsformen ein derartiges Feld 9 appliziert werden, daß beispielsweise eine Phasenschiebung von 45° oder 90° möglich ist. Da durch das Hindurchgreifen des phasenschiebenden Elements 11 durch den Bereich der Elektronenstrahlen 15 höherer Beugungsordnungen diese teilweise abgeschattet werden, ist in bekannter Weise eine Rekonstruktion erforderlich.

**Fig. 7** zeigt ein Ausführungsbeispiel eines phasenschiebenden Elements 12 zur Beeinflussung der Elektronenstrahlen 15 höherer Beugungsordnungen. Dabei zeigt die **Fig. 7a** einen Schnitt A-B durch das phasenschiebende Element 12 gemäß Fig. 7, wie dies dort eingezeichnet ist. Bei dem phasenschiebenden Element 12 sind entlang eines Schlitzes 23 Elektroden 24 und 24' angeordnet, die im Bereich der optischen Achse 10 unterbrochen sind. In diesem Bereich der optischen Achse 10 befinden sich beidseitig des Schlitzes 23 auf Nullpotential 19 liegende Leiter 25 und 25', die dafür sorgen, daß dort das Feld 9' unterbrochen ist. Die Elektroden 24 und 24' werden außerhalb des Schlitzes 23 von einer U-förmigen Abschirmung 22 umgeben, wobei zwischen den Elektroden 24 und 24' sowie der Abschirmung 22 Isolatoren 37 angeordnet sind. Dabei verläuft die z-Achse in Richtung der optischen Achse 10 und in der Waagerechten der Fig. 7 verläuft die x-Achse. Der Schlitz 23 weist eine Breite 26 auf, die derart bemessen ist, daß die Breite 7' der anamorphotischen Abbildung 6 gerade noch durch den Schlitz 23 hindurchpaßt. Der Schlitz 23 ist dabei etwas länger als die Länge 7 der anamorphotischen Abbildung 6. Desweiteren ist der Anschluß der Elektroden 24 und 24' sowie der Abschirmung 22 und der mit dieser verbundenen, auf Nullpotential 19 liegenden Leiter 25 und 25' mit einer Spannungsquelle U dargestellt.

**Fig. 7b** zeigt, wie durch die Elektroden 24 und 24' ein elektrisches Feld 9' im Bereich der Elektronenstrahlen 15 höherer Beugungsordnungen appliziert wird. Das Potential U des elektrischen Feldes 9' ist entsprechend der gewünschten Phasenschiebung bemessen, wie dies bereits oben erläutert wurde. Durch die auf Nullpotential 19 liegenden Leiter 25, 25' ist gewährleistet, daß der Bereich 14 des Nullstrahls 13 auf Nullpotential 19 liegt.

Die zeichnerischen Darstellungen sind selbstverständlich nur beispielhaft, so können die erfindungsgemäßen Vorrichtungen 1, 2 oder 3 auch noch weitere Elemente zu weiteren Zwecken aufweisen, oder die Funktionen der gezeichneten Quadrupolelemente können jeweils auf mehrere Quadrupolelemente aufgeteilt werden.

Die phasenschiebenden Elemente 11 und 12 sind lediglich zwei beispielhafte Ausführungsformen, um eine Applikation im Bereich 14 des Nullstrahls 13 oder im Bereich der Elektronenstrahlen 15 höherer Beugungsordnungen zu erzeugen, weitere funktionsgleiche phasenschiebende Elemente, von denen der Stand der Technik verschiedene Ausführungsformen lehrt, können entsprechend eingesetzt werden.

**Bezugszeichenliste**

| | |
|---|---|
| $Q_1$, $Q_5$ | Quadrupolelemente auf der Eingangs- und Ausgangsseite der Vorrichtung |
| $Q_2$, $Q_4$ | Quadrupolelemente vor und nach der Beugungs-Zwischenbildebene |
| $Q_3$ | zentrales Quadrupolelement |
| $Q_{11}$, $Q_{12}$, $Q_{13}$, $Q_{14}$, $Q_{15}$ | Quadrupolelemente entsprechend den oben aufgeführten in der zweiten Hälfte einer doppelten Anordnung |
| $Q_1'$, $Q_2'$, $Q_3'$, $Q_4'$, ..., $Q_{15}'$ | Quadrupolfelder der oben aufgeführten Quadrupolelemente |
| $x_\alpha$, $y_\beta$ | Axialstrahlen |
| $x_\gamma$, $y_\delta$ | Feldstrahlen |

| | |
|---|---|
| 1 | Vorrichtung zur Bildkontrasterzeugung, einfachsymmetrischer Aufbau |
| 1' | Vorrichtung zur Bildkontrasterzeugung wie 1, aber umgekehrt gepolt |
| 2 | Vorrichtung zur Bildkontrasterzeugung, doppelsymmetrischer Aufbau (1 = erster Vorrichtungsteil, 1' = zweiter Vorrichtungsteil) |
| 3 | Vorrichtung zur Bildkontrasterzeugung mit einer Vereinfachung des doppelsymmetrischen Aufbaus |
| 4 | Objekt |
| 5 | Zwischenbild mit der Vergrößerung M |
| 5' | weiteres Zwischenbild mit der Vergrößerung M |
| 5" | drittes Zwischenbild mit der Vergrößerung M |
| 6 | anamorphotische Abbildung |
| 6' | weitere anamorphotische Abbildung |
| 7 | Länge der anamorphotischen Abbildung |
| 7' | Breite der anamorphotischen Abbildung |
| 8 | Beugungs- Zwischenbildebene |
| 9 | elektrisches Feld, im Bereich des Nullstrahls appliziert |
| 9' | elektrisches Feld, im Bereich der gebeugten Strahlen appliziert |
| 10 | optische Achse |
| 11 | phasenschiebendes Element, erste Ausführungsform |
| 12 | phasenschiebendes Element, zweite Ausführungsform |
| 13 | Nullstrahl (Elektronenstrahl nullter Beugungsordnung) |
| 14 | Bereich des Nullstrahls |
| 15 | Elektronenstrahlen höherer Beugungsordnungen |
| 16 | astigmatisches Zwischenbild im Bereich der Quadrupolfelder $Q_2'$, $Q_4'$ oder $Q_{12}'$, $Q_{14}'$ |

| 17 | Objektiv |
| 18 | Projektivlinsensystem |
| 19 | Nullpotential |
| 20 | abgeschirmter Leiter |
| 21 | Ende des abgeschirmten Leiters |
| 22 | Abschirmung |
| 23 | Schlitz |
| 24,24' | Elektroden |
| 25, 25' | auf Nullpotential liegende Leiter |
| 26 | Breite des Schlitzes |
| 27 | Beugungs- Zwischenbild zwischen Objektivlinse und Vorrichtung |
| 28 | verkleinertes virtuelles Beugungs- Zwischenbild |
| 29 | Symmetrieebenen der Vorrichtung 1 |
| 29' | entsprechende Symmetrieebenen der einzelnen Teile eines doppelsymmetrischen Aufbaus 2 |
| 30 | Strahlenverlauf |
| 31 | Elektronenmikroskop |
| 32 | zentrale Symmetrieebene (Vorrichtung) bzw. Ebene der Antisymmetrie (Felder) der Vorrichtung 2 mit doppelsymmetrischem Aufbau |
| 33 | Symmetrieebene einer Vorrichtung 3 |
| 34 | Strahlenquelle |
| 35 | Kondensor |
| 36 | Projektionsfläche |
| 37 | Isolator |

## Patentansprüche

1. Verfahren zur Bildkontrasterzeugung durch Phasenschiebung in der Elektronenoptik, wobei ausgehend von einem Zwischenbild (5) durch Quadrupolfelder ($Q_1'$, $Q_2'$, $Q_3'$; $Q_{11}'$, $Q_{12}'$, $Q_{13}'$) eine anamorphotische Abbildung (6, 6') der Axialstrahlen ($x_\alpha$, $y_\beta$) bei gleichzeitigem Nulldurchgang der Feldstrahlen ($x_\gamma$, $y_\delta$) in mindestens einer Beugungs-Zwischenbildebene (8, 8') erzeugt wird, dort durch ein magnetisches oder elektrisches Feld (9, 9') eine relative Phasenschiebung zwischen einem Bereich (14) um den Elektronenstrahl nullter Beugungsordnung (13) und den Elektronenstrahlen höherer Beugungsordnungen (15) bewirkt wird und danach durch weitere Quadrupolfelder ($Q_3'$, $Q_4'$, $Q_5'$; $Q_{13}'$, $Q_{14}'$, $Q_{15}'$) die mindestens eine erzeugte Anamorphie des Strahlengangs wieder kompensiert wird,
**dadurch gekennzeichnet,**
**daß** zur Erzeugung und Kompensation der mindestens einen anamorphotischen Abbildung (6, 6') unmittelbar vor und nach dieser Abbildung (6, 6') angeordnete Quadrupolelemente ($Q_2$, $Q_4$; $Q_{12}$, $Q_{14}$) dienen, die eine derartige Ausdehnung in Richtung der optischen Achse (10) und eine derartige Stärke aufweisen, daß sie ein astigmatisches Zwischenbild (16) in ihrem Wirkungsbereich erzeugen, wobei die Stärke derart groß gewählt ist, daß sich die axiale Feldausdehnung in das optische System eines Elektronenmikroskops (31) einfügen läßt, und wobei mindestens einer der Axialstrahlen ($x_\alpha$, $y_\beta$) durch die entsprechende Wahl einer starken Vergrößerung M des Zwischenbildes (5) unter einer derart geringen Steigung $\frac{1}{M}$ in das Quadrupol-feld ($Q_2'$; $Q_{12}'$) des Quadrupolelementes ($Q_2$, $Q_{12}$) unmittelbar vor der mindestens einen anamorphotischen Abbildung (6, 6') einläuft, daß ihr Aspektverhältnis deutlich vergrößert wird, jedoch die Länge (7) der anamorphotischen Abbildung (6, 6') nicht derart überschritten wird, daß sich die Bildqualität in einer Weise verschlechtert, die für die Bildauswertung in irgend einer Weise nachteilig wäre.

2. Verfahren nach Anspruch 1,
**dadurch gekennzeichnet,**
**daß** nur eine anamorphotische Abbildung (6) erzeugt wird.

3. Verfahren nach Anspruch 2,
**dadurch gekennzeichnet,**
**daß** das in der anamorphotischen Abbildung (6) wirkende magnetische oder elektrische Feld (9, 9') eine derartige Feldstärke aufweist, daß eine relative Phasenschiebung von näherungsweise 90° bewirkt wird.

4. Verfahren nach Anspruch 1,

**dadurch gekennzeichnet,**

**daß** mittels eines antisymmetrischen Strahlenverlaufs ($x_\alpha$, $y_\beta$, $x_\gamma$, $y_\delta$) zwei um 90° gedrehte anamorphotische Abbildungen (6, 6') erzeugt werden, wobei die Antisymmetrie in einer zweiten Anordnung von Quadrupolfeldern ($Q_{11}'$, $Q_{12}'$, $Q_{13}'$, $Q_{14}'$, $Q_{15}'$ oder $Q_{11}'$, $Q_{12}'$, $Q_{13}'$, $Q_{14}'$) gegenüber einer ersten Anordnung von Quadrupolfeldern ($Q_1'$, $Q_2'$, $Q_3'$, $Q_4'$, $Q_5'$ oder $Q_1'$, $Q_2'$, $Q_3'$, $Q_4'$) bewirkt wird, indem letztere betragsgleich oder im Wesentlichen betragsgleich aber umgekehrt gepolt sind.

5. Verfahren nach Anspruch 4,
   **dadurch gekennzeichnet,**
   **daß** eine Ebene (32, 33) der Antisymmetrie derart gewählt ist, daß ein vor dem ersten Quadrupolfeld ($Q_1'$) liegendes Zwischenbild (5) der Vergrößerung M als weiteres Zwischenbild (5') der Vergrößerung M in dieser Ebene (32, 33) und einem dritten Zwischenbild (5") nach dem Quadrupolfeld ($Q_{15}'$) abgebildet ist.

6. Verfahren nach Anspruch 4 oder 5,
   **dadurch gekennzeichnet,**
   **daß** die jeweils in diesen anamorphotischen Abbildungen (6, 6') wirkenden magnetischen oder elektrischen Felder (9, 9') eine derartige Feldstärke aufweisen, daß jeweils eine relative Phasenverschiebung von näherungsweise 45° bewirkt wird.

7. Verfahren nach einem der Ansprüche 1 bis 6,
   **dadurch gekennzeichnet,**
   **daß** das magnetische oder elektrische Feld (9) im Bereich (14) des Nullstrahls (13) appliziert wird.

8. Verfahren nach einem der Ansprüche 1 bis 6,
   **dadurch gekennzeichnet,**
   **daß** das magnetische oder elektrische Feld (9') im Bereich der gebeugten Strahlen (15) appliziert wird.

9. Verfahren nach einem der Ansprüche 1 bis 8,
   **dadurch gekennzeichnet,**
   **daß** eine anamorphotische Abbildung (6) mit einem Aspektverhältnis größer als 100 erzielt wird.

10. Verfahren nach Anspruch 9,
    **dadurch gekennzeichnet,**
    **daß** eine anamorphotische Abbildung (6) mit einem Aspektverhältnis größer als 200 erzielt wird.

11. Vorrichtung (1) zur Durchführung eines Verfahrens nach einem der Ansprüche 1 bis 10 mit eingangsseitigen Quadrupolelementen ($Q_1$, $Q_2$), die ausgehend von einem Zwischenbild (5) derartige Quadrupolfelder ($Q_1'$, $Q_2'$) erzeugen, daß die Axialstrahlen ($x_\alpha$, $y_\beta$) und die Feldstrahlen ($x_\gamma$, $y_\delta$) in zwei senkrechten Schnitten (x und y) derart fokussiert bzw. defokussiert werden, daß in einer Beugungs-Zwischenbildebene (8) die Axialstrahlen ($x_\alpha$, $y_\beta$) eine anamorphotische Abbildung (6) bilden und die Feldstrahlen ($x_\gamma$, $y_\delta$) jeweils durch Null gehen, wobei im Bereich der Beugungs-Zwischenbildebene (8) ein zentrales Quadrupolelement ($Q_3$) mit einem derartigen Quadrupolfeld ($Q_3'$) angeordnet ist, daß die Axialstrahlen ($x_\alpha$, $y_\beta$) das Feld ($Q_3'$) mit Steigungen verlassen, die gegenüber dem Eintritt in das Feld ($Q_3'$) entgegengesetzt verlaufen, und wobei zwei weitere Quadrupolelemente ($Q_4$, $Q_5$) Quadrupolfelder ($Q_4'$, $Q_5'$) erzeugen, die zu den Quadrupolfeldern ($Q_1'$, $Q_2'$) der eingangsseitigen Quadrupolelemente ($Q_1$, $Q_2$) betrags- und vorzeichengleich sind, so daß die Anamorphie des Strahlengangs wieder kompensiert wird, und wobei in der Beugungs- Zwischenbildebene (8) ein phasenschiebendes Element (11, 12) angeordnet ist, dessen magnetisches oder elektrisches Feld (9, 9') derart eingerichtet ist, daß eine relative Phasenschiebung zwischen dem Bereich (14) des Elektronenstrahls nullter Beugungsordnung (13) und den Elektronenstrahlen höherer Beugungsordnungen (15) bewirkt wird,
    **dadurch gekennzeichnet,**
    **daß** die der Beugungs- Zwischenbildebene (8) unmittelbar vor- und nachgeordneten Quadrupolelemente ($Q_2$, $Q_4$) eine Ausdehnung in Richtung der optischen Achse (10) und eine derartige Stärke aufweisen, daß sie ein astigmatische Zwischenbild (16) in ihrem Wirkungsbereich erzeugen, wobei die Stärke derart groß gewählt ist, daß sich die axiale Feldausdehnung in das optische System eines Elektronenmikroskops (31) an eine Stelle des Strahlengangs des Projektivlinsensystems (18) einfügen läßt, und wobei mindestens einer der Axialstrahlen ($x_\alpha$, $y_\beta$) durch die entsprechende Wahl einer starken Vergrößerung M des Zwischenbildes (5) unter einer derart geringen Steigung

$\dfrac{1}{M}$ in das Quadrupolfeld (Q$_2$'; Q$_{12}$') des Quadrupolelementes (Q$_2$, Q$_{12}$) unmittelbar vor der mindestens einen anamorphotischen Abbildung (6, 6') einläuft,

**daß** ihr Aspektverhältnis deutlich vergrößert wird, jedoch die Länge (7) der anamorphotischen Abbildung (6, 6') nicht derart überschritten wird, daß sich die Bildqualität in einer Weise verschlechtert, die für die Bildauswertung in irgend einer Weise nachteilig wäre.

12. Vorrichtung nach Anspruch 11,
    **dadurch gekennzeichnet,**
    **daß** das phasenschiebende Element (11, 12) zur Erzeugung eines eine relative Phasenschiebung von näherungsweise 90° bewirkenden magnetischen oder elektrischen Feldes (9, 9') ausgebildet ist.

13. Vorrichtung nach Anspruch 11,
    **dadurch gekennzeichnet,**
    **daß** ihr auf der optischen Achse (10) eine zweite Vorrichtung (1') nachgeordnet ist, deren Quadrupolelemente (Q$_{11}$, Q$_{12}$, Q$_{13}$, Q$_{14}$, Q$_{15}$) den Quadrupolelementen (Q$_1$, Q$_2$, Q$_3$, Q$_4$, Q$_5$) der ersten Vorrichtung (1) entsprechen, deren Felder (Q$_{11}$', Q$_{12}$', Q$_{13}$', Q$_{14}$', Q$_{15}$') jedoch umgekehrt gepolt sind, so daß die anamorphotische Abbildung (6') gegenüber der anamorphotischen Abbildung (6) der ersten Vorrichtung (1) um 90° gedreht ist, daß die gesamte aus der ersten (1) und zweiten Vorrichtung (1') zusammengesetzte Vorrichtung (2) im Strahlengang des Projektivlinsensystems (18) des Elektronenmikroskops (31) derart anordenbar ausgebildet ist, daß das Zwischenbild (5) vor dem ersten Quadrupolelement (Q$_1$) liegt und in der durch diese Zusammenfügung entstehenden zentralen Symmetrieebene (32) ein weiteres Zwischenbild (5') der Vergrößerung M gebildet wird, und daß das phasenschiebende Element (11, 12) der zweiten Vorrichtung (1') derart angeordnet ist, daß sie magnetische oder elektrische Felder (9, 9') zur relativen Phasenschiebung zwischen dem Bereich (14) des Elektronenstrahls nullter Beugungsordnung (13) und den Elektronenstrahlen höherer Beugungsordnungen (15) dieser zweiten anamorphotischen Abbildung (6') bereitstellt.

14. Vorrichtung (3) zur Durchführung eines Verfahrens nach einem der Ansprüche 1 bis 10 mit eingangsseitigen Qua-drupolelementen (Q$_1$, Q$_2$), die ausgehend von einem Zwischenbild (5) derartige Quadrupolfelder (Q$_1$', Q$_2$') erzeugen, daß die Axialstrahlen (x$_\alpha$, y$_\beta$) und die Feldstrahlen (x$_\gamma$, y$_\delta$) in zwei senkrechten Schnitten (x und y) derart fokussiert bzw. defokussiert werden, daß in einer Beugungs-Zwischenbildebene (8) die Axialstrahlen (x$_\alpha$, y$_\beta$) eine anamor-photische Abbildung (6) bilden und die Feldstrahlen (x$_\gamma$, y$_\delta$) jeweils durch Null gehen, wobei im Bereich der Beugungs-Zwischenbildebene (8) ein erstes zentrales Quadrupolelement (Q$_3$) mit einem derartigen Quadrupolfeld (Q$_3$') an-geordnet ist, daß die Axialstrahlen (x$_\alpha$, y$_\beta$) das Feld (Q$_3$') mit entgegengesetzten Steigungen verlassen, wie sie in das Feld (Q$_3$') eingetreten sind, und wobei in der Beugungs- Zwischenbildebene (8) ein erstes phasenschiebendes Element (11, 12) angeordnet ist, dessen magnetisches oder elektrisches Feld (9, 9') derart eingerichtet ist, daß eine relative Phasenschiebung zwischen dem Bereich (14) des Elektronenstrahls nullter Beugungsordnung (13) und den Elektronenstrahlen höherer Beugungsordnungen (15) bewirkt wird,
    **dadurch gekennzeichnet,**
    **daß** der Beugungs-Zwischenbildebene (8) ein Quadrupolelement (Q$_4$) nachgeordnet ist und die der Beugungs-Zwischenbildebene unmittelbar vor- und nachgeordneten Quadrupolelemente (Q$_2$, Q$_4$) eine derartige Ausdehnung in Richtung der optischen Achse (10) und eine derartige Stärke aufweisen, daß sie ein astigmatisches Zwischenbild (16) in ihrem Wirkungsbereich erzeugen, wobei die Stärke derart groß gewählt ist, daß sich die axiale Feldausdehnung in das optische System eines Elektronenmikroskops (31) einfügen läßt, daß nach einer bezüglich aller Quadrupolelemente zentralen Symmetrieebene (33) drei Quadrupolelemente (Q$_{12}$, Q$_{13}$, Q$_{14}$) folgen, deren Felder (Q$_{12}$', Q$_{13}$', Q$_{14}$') im Wesentlichen betragsgleich zu den Feldern (Q$_2$', Q$_3$', Q$_4$') der davorliegenden drei Quadrupolelemente (Q$_2$, Q$_3$, Q$_4$) jedoch um 90° gedreht sind, daß dann ein Quadrupol (Q$_{15}$) mit einem Feld (Q$_{15}$') folgt, das betragsgleich aber um 90° gedreht zum Feld (Q$_1$') des ersten Quadrupols (Q$_1$) ist, daß die Felder (Q$_2$') und (Q$_4$') der vor und nach der Beugungs- Zwischenbildebene (8) liegenden Quadrupolelemente (Q$_2$, Q$_4$) derart voneinander abweichend einstellbar sind, daß die Axialstrahlen (x$_\alpha$, y$_\beta$) in der zentralen Symmetrieebene (33) ein weiteres Zwischenbild (5') der Vergrößerung M bilden und sich die Feldstrahlen (x$_\gamma$, y$_\delta$) schneiden, und wobei die entsprechenden Quadrupo-lelemente (Q$_{12}$, Q$_{14}$) nach der zentralen Symmetrieebene (33), deren Felder (Q$_{12}$', Q$_{14}$') um 90° gedreht sind, ebenfalls abweichend einstellbar sind, so daß am Ende der Vorrichtung (3) ein drittes Zwischenbild (5") der Größe M entsteht, so daß die Axialstrahlen (x$_\alpha$, y$_\beta$) und die Feldstrahlen (x$_\gamma$, y$_\delta$) diese Felder (Q$_{12}$', Q$_{13}$', Q$_{14}$', Q$_{15}$') im x-

Schnitt so durchlaufen wie die ersten vier Felder ($Q_1'$, $Q_2'$, $Q_3'$, $Q_4'$) im y-Schnitt und im y-Schnitt wie zuvor im x-Schnitt, wobei im zweiten zentralen Quadrupolelement ($Q_{13}$) eine zweite Beugungs- Zwischenbildebene mit einer weiteren anamorphotischen Abbildung (6') entsteht, die zur ersten anamorphotischen Abbildung (6) um 90° gedreht ist, daß in der zweiten Beugungs- Zwischenbildebene ein zweites phasenschiebendes Element (11, 12) angeordnet ist, dessen magnetisches oder elektrisches Feld (9, 9') derart eingerichtet ist, daß eine relative Phasenschiebung zwischen einem Bereich (14) des Elektronenstrahls nullter Beugungsordnung (13) und den Elektronenstrahlen höherer Beugungsordnungen (15) bewirkt wird, und daß die Vorrichtung (3) für eine Anordnung an einer Stelle des Strahlengangs eines Projektivlinsensystems (18) eines Elektronenmikroskops (31) ausgebildet ist, an der die Axialstrahlen ($x_\alpha$, $y_\beta$) ein Zwischenbild (5) mit einer so starken Vergrößerung M bilden, daß sie in das Quadrupolfeld ($Q_2'$) des zweiten Quadrupols ($Q_2$) unmittelbar vor der anamorphotischen Abbildung (6) mit einer derartigen Steigung $\dfrac{1}{M}$ einlaufen, daß ihr Aspektverhältnis deutlich vergrößert wird, jedoch die Länge (7) der anamorphotischen Abbildung (6) nicht derart überschritten wird, daß sich die Bildqualität in einer Weise verschlechtert, die für die Bildauswertung in irgend einer Weise nachteilig wäre.

15. Vorrichtung nach Anspruch 13 oder 14,
**dadurch gekennzeichnet,**
**daß** die phasenschiebenden Elemente (11, 12) magnetische oder elektrische Felder (9, 9') aufweisen, die eine Phasenschiebung von jeweils näherungsweise 45° bewirken.

16. Vorrichtung nach einem der Ansprüche 11 bis 15,
**dadurch gekennzeichnet,**
**daß** das mindestens eine phasenschiebende Element (11) derart ausgebildet ist, daß mit ihm ein magnetisches oder elektrisches Feld (9) im Bereich (14) des Nullstrahls (13) applizierbar ist und der Bereich der gebeugten Strahlen (15) auf Nullpotential (19) liegt.

17. Vorrichtung nach Anspruch 16,
**dadurch gekennzeichnet,**
**daß** das phasenschiebende Element (11) zur Erzeugung eines elektrischen Feldes (9) als abgeschirmter Leiter (20) ausgebildet ist, der von einer Befestigung an der Gehäusewand ausgehend in der Beugungs- Zwischenbildebene (8, 8') im Wesentlichen radial in Richtung des Bereichs (14) des Nullstrahls (13) erstreckend angeordnet ist, wobei der abgeschirmte Leiter (20) vor dem Bereich (14) des Nullstrahls (13) ein derart positioniertes Ende (21) aufweist, daß zwischen dem Leiter (20) und der ihn umgebenden Abschirmung (22) ein elektrisches Feld (9) gebildet wird, das diesen Bereich (14) des Nullstrahls (13) erfaßt.

18. Vorrichtung nach einem der Ansprüche 11 bis 17,
**dadurch gekennzeichnet,**
**daß** das mindestens eine phasenschiebende Element (12) derart ausgebildet ist, daß der Bereich (14) des Nullstrahls (13) auf Nullpotential (19) liegt und ein magnetisches oder elektrisches Feld (9') im Bereich der gebeugten Strahlen (15) applizierbar ist.

19. Vorrichtung nach Anspruch 18,
**dadurch gekennzeichnet,**
**daß** das phasenschiebend Element (12) zur Erzeugung eines elektrischen Feldes (9) einen Schlitz (23) aufweist, der die anamorphotische Abbildung (6, 6') einschließt, wobei sich beidseitig entlang des Schlitzes (23) Elektroden (24, 24') für die Applikation des elektrischen Feldes (9') erstrecken, die für den Bereich (14) des Nullstrahls (13) im Bereich der optischen Achse (10) durch je einen auf Nullpotential (19) liegenden Leiter (25, 25') unterbrochen sind.

20. Vorrichtung nach Anspruch 19,
**dadurch gekennzeichnet,**
**daß** sie derart eingerichtet ist, daß die Quadrupole ($Q_2$, $Q_4$, $Q_{12}$, $Q_{14}$) vor und nach der Beugungs- Zwischenebene (8, 8') derartige Felder ($Q_2'$, $Q_4'$, $Q_{12}'$, $Q_{14}'$) erzeugen, daß die Breite (7') der anamorphotischen Abbildung (6, 6') gerade noch in die Breite (26) des Schlitzes (23) hineinpaßt.

21. Vorrichtung nach einem der Ansprüche 11 bis 20,
**dadurch gekennzeichnet,**

**daß** mit den Quadrupolen (Q$_2$, Q$_4$, Q$_{12}$, Q$_{14}$) derartige Feldstärken (Q$_2$', Q$_4$', Q$_{12}$', Q$_{14}$') erzeugbar sind und daß die Anordnung der Vorrichtung (1, 2, 3) an einer derartigen Stelle des Strahlengangs des Projektivlinsensystems (18) eines Elektronenmikroskops (31) vornehmbar ist, die eine derartige Vergrößerung M des Zwischenbildes (5) aufweist, daß sich eine derartige Steigung $\dfrac{1}{M}$ der Axialstrahlen (x$_\alpha$, y$_\beta$) ergibt, daß das Aspektverhältnis der mindestens einen anamorphotischen Abbildung (6, 6') größer als 100 ist.

**22.** Vorrichtung nach Anspruch 21,
**dadurch gekennzeichnet,**
**daß** mit den Quadrupolen (Q$_2$, Q$_4$, Q$_{12}$, Q$_{14}$) derartige Feldstärken (Q$_2$', Q$_4$', Q$_{12}$', Q$_{14}$') erzeugbar sind und daß die Anordnung der Vorrichtung (1, 2, 3) an einer derartigen Stelle des Strahlengangs des Projektivlinsensystems (18) eines Elektronenmikroskops (31) vornehmbar ist, die eine derartige Vergrößerung M des Zwischenbildes (5) aufweist, daß sich eine derartige Steigung $\dfrac{1}{M}$ der Axialstrahlen (x$_\alpha$, y$_\beta$) ergibt, daß das Aspektverhältnis der mindestens einen anamorphotischen Abbildung (6, 6') größer als 200 ist.

**Claims**

1. A method for image contrast generation by phase shifting in the electron optics, where, proceeding from an intermediate image (5), quadrupole fields (Q$_1$', Q$_2$', Q$_3$'; Q$_{11}$', Q$_{12}$', Q$_{13}$') are used to generate an anamorphic reproduction (6, 6') of the axial beams (x$_\alpha$, y$_\beta$) with simultaneous zero crossing of the field beams (x$_\gamma$, y$_\delta$) in at least one diffraction intermediate image plane (8, 8'), where a magnetic or electrical field (9, 9') is used to effect a relative phase shift between a region (14) around the electron beam of zeroth diffraction order (13) and the electron beams of higher diffraction orders (15), and then further quadrupole fields (Q$_3$', Q$_4$', Q$_5$'; Q$_{13}$', Q$_{14}$', Q$_{15}$') are used to compensate the at least one generated anamorphy of the beam path again,
**characterised in that**
to generate and compensate the at least one anamorphic reproduction (6, 6'), quadrupole elements (Q$_2$, Q$_4$; Q$_{12}$, Q$_{14}$) are used, which are arranged immediately in front of and behind said reproduction (6, 6') and have such an extent in the direction of the optical axis (10) and such a strength that they generate an astigmatic intermediate image (16) in in the effective region of said elements, wherein the strength is selected to be such a size that the axial field extent can be introduced into the optical system of an electron microscope (31), and wherein at least one of the axial beams (x$_\alpha$, y$_\beta$) enters the quadrupole field (Q$_2$'; Q$_{12}$') of the quadrupole element (Q$_2$, Q$_{12}$) immediately in front of the at least one anamorphic reproduction (6, 6') owing to the corresponding selection of a strong magnification M of the intermediate image (5) at such a small gradient 1/M that the aspect ratio of said reproduction is considerably increased, but the length (7) of the anamorphic reproduction (6, 6') is not exceeded so that the image quality is impaired in any way that would be disadvantageous for the assessment of the image.

2. The method according to Claim 1,
**characterised in that**
only one anamorphic reproduction (6) is generated.

3. The method according to Claim 2,
**characterised in that**
the magnetic or electrical field (9, 9') effective in the anamorphic reproduction (6) has a field strength such that a relative phase shift of approximately 90° is effected.

4. The method according to Claim 1,
**characterised in that**
an antisymmetric beam profile (x$_\alpha$, y$_\beta$, x$_\gamma$, y$_\delta$) is used to generate two anamorphic reproductions (6, 6') rotated 90°, wherein the antisymmetry is effected in a second arrangement of quadrupole fields (Q$_{11}$', Q$_{12}$', Q$_{13}$', Q$_{14}$', Q$_{15}$' or Q$_{11}$', Q$_{12}$', Q$_{13}$', Q$_{14}$') opposite a first arrangement of quadrupole fields (Q$_1$', Q$_2$', Q$_3$', Q$_4$', Q$_5$' or Q$_1$', Q$_2$', Q$_3$', Q$_4$') by polarising the latter by the same magnitude or substantially the same magnitude but reversed.

5. The method according to Claim 4,
**characterised in that**

a plane (32, 33) of the antisymmetry is selected such that an intermediate image (5) of magnification M situated in front of the first quadrupole field ($Q_1$') is reproduced as a further intermediate image (5') of magnification M in said plane (32, 33), and a third intermediate image (5") is reproduced behind the quadrupole field (Q15').

6. The method according to Claim 4 or 5,
**characterised in that**
the magnetic or electrical fields (9, 9') that are each effective in said anamorphic reproductions (6, 6') have a field strength such that a relative phase shift of approximately 45° is effected in each case.

7. The method according to any one of Claims 1 to 6,
**characterised in that**
the magnetic or electrical field (9) is applied in the region (14) of the zero beam (13).

8. The method according to any one of Claims 1 to 6,
**characterised in that**
the magnetic or electrical field (9') is applied in the region of the diffracted beams (15).

9. The method according to any one of Claims 1 to 8,
**characterised in that**
an anamorphic reproduction (6) with an aspect ratio of greater than 100 is achieved.

10. The method according to Claim 9,
**characterised in that**
an anamorphic reproduction (6) with an aspect ratio of greater than 200 is achieved.

11. A device (1) for carrying out a method according to any one of Claims 1 to 10, having quadrupole elements ($Q_1$, $Q_2$) on the input side, which, proceeding from an intermediate image (5), generate such quadrupole fields ($Q_1$', $Q_2$') that the axial beams ($x_\alpha$, $y_\beta$) and the field beams ($x_\gamma$, $y_\delta$) are focused and defocused in two perpendicular sections (x and y) such that, in one diffraction intermediate image plane (8), the axial beams ($x_\alpha$, $y_\beta$) form an anamorphic reproduction (6) and the field beams ($x_\gamma$, $y_\delta$) each pass through zero, wherein a central quadrupole element ($Q_3$) is arranged in the region of the diffraction intermediate image plane (8), said quadrupole element having such a quadrupole field ($Q_3$') that the axial beams ($x_\alpha$, $y_\beta$) exit the field ($Q_3$') at gradients that run in the opposite direction to the entry into the field ($Q_3$'), and wherein two further quadrupole elements ($Q_4$, $Q_5$) generate quadrupole fields ($Q_4$', $Q_5$') that have the same magnitude and sign as the quadrupole fields ($Q_1$', $Q_2$') of the quadrupole elements ($Q_1$, $Q_2$) on the input side, so the anamorphy of the beam path is compensated again, and wherein a phase-shifting element (11, 12) is arranged in the diffraction intermediate image plane (8), the magnetic or electrical field (9, 9') of said phase-shifting element being designed such that a relative phase shift is effected between the region (14) of the electron beam of zeroth diffraction order (13) and the electron beams of higher diffraction orders (15),
**characterised in that**
the quadrupole elements ($Q_2$, $Q_4$) that are arranged immediately in front of and behind the diffraction intermediate image plane (8) have an extent in the direction of the optical axis (10) and such a strength that they generate an astigmatic intermediate image (16) in the effective region of said elements, wherein the strength is selected to be such a size that the axial field extent can be introduced into the optical system of an electron microscope (31) at a point in the beam path of the projective lens system (18), and wherein at least one of the axial beams ($x_\alpha$, $y_\beta$) enters the quadrupole field ($Q_2$'; $Q_{12}$') of the quadrupole element ($Q_2$, $Q_{12}$) immediately in front of the at least one anamorphic reproduction (6, 6') owing to the corresponding selection of a strong magnification M of the intermediate image (5) at such a small gradient 1/M that the aspect ratio of said reproduction is considerably increased, but the length (7) of the anamorphic reproduction (6, 6') is not exceeded so that the image quality is impaired in any way that would be disadvantageous for the assessment of the image.

12. The device according to Claim 11,
**characterised in that**
the phase-shifting element (11, 12) is configured to generate a magnetic or electrical field (9, 9') that effects a relative phase shift of approximately 90°.

13. The device according to Claim 11,
**characterised in that**
a second device (1') is arranged behind it on the optical axis (10), the quadrupole elements ($Q_1$, $Q_{12}$, $Q_{13}$, $Q_{14}$, $Q_{15}$)

of said second device corresponding to the quadrupole elements ($Q_1$, $Q_2$, $Q_3$, $Q_4$, $Q_5$) of the first device (1), but the fields ($Q_{11}$', $Q_{12}$', $Q_{13}$', $Q_{14}$', $Q_{15}$') being polarised in a reversed manner, so that the anamorphic reproduction (6') is rotated 90° with respect to the anamorphic reproduction (6) of the first device (1), that the entire device (2) composed of the first (1) and second device (1') can be arranged in the beam path of the projective lens system (18) of the electron microscope (31) in such a manner that the intermediate image (5) lies in front of the first quadrupole element ($Q_1$) and, in the central plane of symmetry (32) produced by this combination, a further intermediate image (5') of magnification M is formed, and that the phase-shifting element (11, 12) of the second device (1') is arranged such that it provides magnetic or electrical fields (9, 9') for relative phase-shifting between the region (14) of the electron beam of zeroth diffraction order (13) and the electron beams of higher diffraction orders (15) of said second anamorphic reproduction (6').

14. A device (3) for carrying out a method according to any one of Claims 1 to 10, having quadrupole elements ($Q_1$, $Q_2$) on the input side, which, proceeding from an intermediate image (5), generate such quadrupole fields ($Q_1$', $Q_2$') that the axial beams ($x_\alpha$, $y_\beta$) and the field beams ($x_\gamma$, $y_\delta$) are focused and defocused in two perpendicular sections (x and y) such that, in one diffraction intermediate image plane (8), the axial beams ($x_\alpha$, $y_\beta$) form an anamorphic reproduction (6) and the field beams ($x_\gamma$, $y_\delta$) each pass through zero, wherein a first central quadrupole element ($Q_3$) is arranged in the region of the diffraction intermediate image plane (8), said quadrupole element having such a quadrupole field ($Q_3$') that the axial beams ($x_\alpha$, $y_\beta$) exit the field ($Q_3$') at gradients that run in the opposite direction to those at which they entered the field ($Q_3$'), and wherein a first phase-shifting element (11, 12) is arranged in the diffraction intermediate image plane (8), the magnetic or electrical field (9, 9') of said phase-shifting element being designed such that a relative phase shift is effected between the region (14) of the electron beam of zeroth diffraction order (13) and the electron beams of higher diffraction orders (15),
**characterised in that**
a quadrupole element ($Q_4$) is arranged behind the diffraction intermediate image plane (8), and the quadrupole elements ($Q_2$, $Q_4$) arranged immediately in front of and behind the diffraction intermediate image plane have such an extent in the direction of the optical axis (10) and such a strength that they generate an astigmatic intermediate image (16) in the effective region of said elements, wherein the strength is selected such that the axial field extent can be introduced into the optical system of an electron microscope (31), that three quadrupole elements ($Q_{12}$, $Q_{13}$, $Q_{14}$) follow behind a plane of symmetry (33) that is central in relation to all the quadrupole elements, the fields ($Q_{12}$', $Q_{13}$', $Q_{14}$') of which elements essentially having the same magnitude as the fields ($Q_2$', $Q_3$', $Q_4$') of the three quadrupole elements ($Q_2$, $Q_3$, $Q_4$) in front but rotated by 90°, that a quadrupole ($Q_{15}$) then follows, with a field ($Q_{15}$') of the same magnitude but rotated by 90° in relation to the field ($Q_1$') of the first quadrupole ($Q_1$), that the fields ($Q_2$') and ($Q_4$') of the quadrupole elements ($Q_2$, $Q_4$) lying in front of and behind the diffraction intermediate image plane (8) can be set differently from each other such that the axial beams ($x_\alpha$, $y_\beta$) form a further intermediate image (5') of magnification M in the central plane of symmetry (33) and the field beams ($x_\gamma$, $y_\delta$) intersect, and wherein the corresponding quadrupole elements ($Q_{12}$, $Q_{14}$) behind the central plane of symmetry (33), the fields ($Q_{12}$', $Q_{14}$') of which are rotated 90°, can likewise be set differently, so that a third intermediate image (5") of magnification M is produced at the end of the device (3), so that the axial beams ($x_\alpha$, $y_\beta$) and the field beams ($x_\gamma$, $y_\delta$) pass through said fields ($Q_{12}$', $Q_{13}$', $Q_{14}$', $Q_{15}$') in the x-section in the same manner as in the y-section in the first four fields ($Q_1$', $Q_2$', $Q_3$', $Q_4$') and in the y-section in the same manner as previously in the x-section, wherein a second diffraction intermediate image plane is produced in the second central quadrupole element ($Q_{13}$), said second diffraction intermediate image having a further anamorphic reproduction (6'), which is rotated 90° in relation to the first anamorphic reproduction (6), that a second phase-shifting element (11, 12) is arranged in the second diffraction intermediate image plane, the magnetic or electrical field (9, 9') of said phase-shifting element being designed such that a relative phase shift is effected between a region (14) of the electron beam of zeroth diffraction order (13) and the electron beams of higher diffraction orders (15), and that the device (3) is configured for arrangement at a point in the beam path of a projective lens system (18) of an electron microscope (31), at which the axial beams ($x_\alpha$, $y_\beta$) form an intermediate image (5) of so strong a magnification M, that they enter the quadrupole field ($Q_2$') of the second quadrupole ($Q_2$) immediately in front of the anamorphic reproduction (6) at such a gradient 1/M that the aspect ratio of said reproduction is considerably increased, but the length (7) of the anamorphic reproduction (6) is not exceeded such that the image quality is impaired in any way that would be disadvantageous for the assessment of the image.

15. The device according to Claim 13 or 14,
**characterised in that**
the phase-shifting elements (11, 12) have magnetic or electrical fields (9, 9') that effect a phase shift of approximately 45° in each case.

**16.** The device according to any one of Claims 11 to 15, **characterised in that** the at least one phase-shifting element (11) is configured in such a manner that it can be used to apply a magnetic or electrical field (9) in the region (14) of the zero beam (13), and the region of the diffracted beams (15) is at zero potential (19).

**17.** The device according to Claim 16, **characterised in that** the phase-shifting element (11) for producing an electrical field (9) is constructed in the form of a shielded conductor (20), which is arranged such that it starts from a fastening on the housing wall and extends in the diffraction intermediate image plane (8, 8') substantially radially in the direction of the region (14) of the zero beam (13), wherein the shielded conductor (20) has an end (21) positioned in front of the region (14) of the zero beam (13) in such a manner that an electrical field (9) that encompasses said region (14) of the zero beam (13) is formed between the conductor (20) and the shielding (22) surrounding same.

**18.** The device according to any one of Claims 11 to 17, **characterised in that** the at least one phase-shifting element (12) is configured such that the region (14) of the zero beam (13) is at zero potential (19) and a magnetic or electrical field (9') can be applied in the region of the diffracted beams (15).

**19.** The device according to Claim 18, **characterised in that** the phase-shifting element (12) for generating an electrical field (9) has a slot (23), which surrounds the anamorphic reproduction (6, 6'), wherein electrodes (24, 24') for applying the electrical field (9') extend along the slot (23) on both sides, said electrodes each being interrupted by one conductor (25, 25') at zero potential (19) in the region of the optical axis (10) for the region (14) of the zero beam (13).

**20.** The device according to Claim 19, **characterised in that** it is designed such that the quadrupoles ($Q_2$, $Q_4$, $Q_{12}$, $Q_{14}$) generate such fields ($Q_2'$, $Q_4'$, $Q_{12}'$, $Q_{14}'$) in front of and behind the diffraction intermediate plane (8, 8') that the width (7') of the anamorphic reproduction (6, 6') only just fits into the width (26) of the slot (23).

**21.** The device according to any one of Claims 11 to 20, **characterised in that** the quadrupoles ($Q_2$, $Q_4$, $Q_{12}$, $Q_{14}$) can be used to generate such field strengths ($Q_2'$, $Q_4'$, $Q_{12}'$, $Q_{14}'$) and that the device (1, 2, 3) can be arranged at such a point in the beam path of the projective lens system (18) of an electron microscope (31) that has such a magnification M of the intermediate image (5) that such a gradient 1/M of the axial beams ($x_\alpha$, $Y_\beta$) is produced that the aspect ratio of the at least one anamorphic reproduction (6, 6') is greater than 100.

**22.** The device according to Claim 21, **characterised in that** the quadrupoles ($Q_2$, $Q_9$, $Q_{12}$, $Q_{14}$) can be used to generate such field strengths ($Q_2'$, $Q_4'$, $Q_{12}'$, $Q_{14}'$) and that the device (1, 2, 3) can be arranged at such a point in the beam path of the projective lens system (18) of an electron microscope (31) that has such a magnification M of the intermediate image (5) that such a gradient 1/M of the axial beams ($x_\alpha$, $Y_\beta$) is produced that the aspect ratio of the at least one anamorphic reproduction (6, 6') is greater than 200.

**Revendications**

**1.** Procédé de génération de contraste d'image par décalage de phase dans l'optique électronique, dans lequel à partir d'une image intermédiaire (5) par des champs quadripolaires ($Q_1'$, $Q_2'$, $Q_3'$, $Q_{11}'$, $Q_{12}'$, $Q_{13}'$) une image anamorphosée (6,6') des rayons axiaux ($x_\alpha$, $y_\beta$) en cas de passage par zéro simultané des rayons de champ ($x_\gamma$, $y_\delta$) dans au moins un plan d'image intermédiaire de diffraction (8,8') est générée, à cet endroit par un champ magnétique ou électrique (9,9') un décalage de phase relatif est produit entre une zone (14)autour du rayon d'électrons d'ordre de diffraction zéro (13) et les rayons d'électrons d'ordres de diffraction supérieurs (15) et ensuite par des champs quadripolaires supplémentaires ($Q_3'$, $Q_9'$, $Q_5'$ $Q_{13}'$, $Q_{14}'$, $Q_{15}'$) au moins une anamorphose générée du trajet de rayons est de nouveau compensée,

**caractérisé en ce que** des éléments quadripolaires (Q$_2$, Q$_4$, Q$_{12}$, Q$_{14}$) disposés directement avant et après cette image (6,6') servent à générer et compenser au moins une image anamorphosée (6,6'), lesquels présentent une expansion telle dans la direction de l'axe optique (10) et une intensité telle qu'ils génèrent une image intermédiaire astigmate (16) dans leur zone d'action, dans lequel l'intensité est choisie à une grandeur telle que l'expansion de champ axiale soit intégrée dans le système optique d'un microscope électronique (31) et dans lequel au moins un des rayons axiaux (x$_\alpha$, y$_\beta$) s'étend par le choix correspondant d'un agrandissement prononcé M de l'image intermédiaire (5) sous une déclivité minime 1/M dans le champ quadripolaire (Q$_2$', Q$_{12}$') de l'élément quadripolaire (Q$_2$, Q$_{12}$) directement avant au moins une image anamorphosée (6,6'), de sorte que son rapport d'aspect soit considérablement agrandi, néanmoins la longueur (7) de l'image anamorphosée (6,6') ne soit pas dépassée, de sorte que la qualité d'image soit dégradée d'une manière, qui serait d'une quelconque manière un inconvénient pour l'estimation d'image.

2. Procédé selon la revendication 1, **caractérisé en ce que** seule une image anamorphosée (6) est générée.

3. Procédé selon la revendication 2, **caractérisé en ce qu'**un champ magnétique ou électrique (9,9') agissant dans l'image anamorphosée (6) présente une intensité de champ telle qu'un décalage de phase relatif d'approximativement 90° est provoqué.

4. Procédé selon la revendication 1, **caractérisé en ce que** au moyen d'un cours de rayon asymétrique (x$_\alpha$, y$_\beta$, x$_\gamma$, y$_\delta$) deux images (6,6') anamorphosées tournées à 90° sont générées, dans lequel l'antisymétrie dans un deuxième agencement de champs quadripolaires (Q$_{11}$', Q$_{12}$', Q$_{13}$', Q$_{14}$', Q$_{15}$' ou Q$_{11}$', Q$_{12}$', Q$_{13}$', Q$_{14}$') est provoqué par rapport à un premier agencement de champs quadripolaires (Q$_1$', Q$_2$', Q$_3$', Q$_4$', Q$_5$' ou Q$_1$', Q$_2$', Q$_3$', Q$_4$'), en polarisant ces derniers dans une même proportion ou essentiellement dans une même proportion mais inversement.

5. Procédé selon la revendication 4, **caractérisé en ce que** un plan (32,33) de l'antisymétrie est choisi de telle sorte qu'une image intermédiaire (5) de l'agrandissement M située avant le premier champ quadripolaire (Q$_1$') soit imagée comme image intermédiaire supplémentaire (5') de l'agrandissement M dans ce plan (32,33) et d'une troisième image intermédiaire (5") après le champ quadripolaire (Q$_{15}$').

6. Procédé selon la revendication 4 ou 5, **caractérisé en ce que** les champs électriques ou magnétiques (9,9') agissant respectivement dans ces images anamorphosées (6,6') présentent une intensité de champ telle que respectivement un décalage de phase relatif d'approximativement 45° soit provoqué.

7. Procédé selon une des revendications 1 à 6, **caractérisé en ce que** le champ électrique ou magnétique (9) est appliqué au niveau (14) du rayon neutre (13).

8. Procédé selon une des revendications 1 à 6, **caractérisé en ce que** un champ électrique ou magnétique (9') est appliqué au niveau des rayons diffractés (15).

9. Procédé selon une des revendications 1 à 8, **caractérisé en ce que** une image anamorphosée (6) avec un rapport d'aspect supérieur à 100 est obtenue.

10. Procédé selon la revendication 9, **caractérisé en ce que** une image anamorphosée (6) avec un rapport d'aspect supérieur à 200 est obtenue.

11. Dispositif (1) pour mettre en oeuvre un procédé selon une des revendications 1 à 6 avec des éléments quadripolaires du côté d'entrée (Q$_1$, Q$_2$), qui génèrent à partir d'une image intermédiaire (5) des champs quadripolaires (Q$_1$', Q$_2$') tels que les rayons axiaux (x$_\alpha$, y$_\beta$) et les rayons de champ (x$_\gamma$, y$_\delta$) soient focalisés, resp. défocalisés dans deux intersections perpendiculaires (x et y), de sorte que dans un plan d'image intermédiaire de diffraction (8) les rayons axiaux (x$_\alpha$, y$_\beta$) forment une image anamorphosée (6) et les rayons de champ (x$_\gamma$, y$_\delta$) passent respectivement par zéro, dans lequel au niveau du plan d'image intermédiaire de diffraction (8) un élément quadripolaire central (Q$_3$) avec un champ quadripolaire (Q$_3$') est disposé, tel que les rayons axiaux (x$_\alpha$, y$_\beta$) quittent le champ (Q$_3$') avec des élévations, qui s'étendent en sens opposé par rapport à l'entrée dans le champ (Q$_3$'), et dans lequel deux éléments quadripolaires supplémentaires (Q$_4$, Q$_5$) génèrent des champs quadripolaires (Q$_4$', Q$_5$'), qui sont identiques en signe et en proportion aux champs quadripolaires (Q$_1$', Q$_2$') des éléments quadripolaires du côté d'entrée (Q$_1$, Q$_2$), de telle sorte que l'anamorphose du trajet de rayon soit de nouveau compensée, et dans lequel dans le plan d'image intermédiaire de diffraction (8) un élément de décalage de phase (11,12) est disposé, dont le champ magnétique ou électrique (9,9') est conçu de telle sorte qu'un décalage de phase relatif entre la zone (14) du rayon d'électrons d'ordre de diffraction zéro (13) et les rayons d'électrons d'ordres de diffraction supérieurs (15) soit provoqué, **caractérisé en ce que**

les éléments quadripolaires (Q$_2$, Q$_4$) disposés directement avant et après le plan d'image intermédiaire de diffraction (8) présentent une expansion dans la direction de l'axe optique (10) et une intensité telle qu'ils génèrent une image intermédiaire astigmate (16) dans leur zone d'action, dans lequel l'intensité est choisie de telle sorte que l'expansion de champ axiale dans le système optique d'un microscope électronique (31) soit intégrée à un emplacement du trajet de rayons du système de lentille projective (18) et dans lequel au moins un des rayons axiaux (x$_\alpha$, y$_\beta$) s'étend par le choix correspondant d'un agrandissement prononcé M de l'image intermédiaire (5) sous une déclivité minime 1/M dans le champ quadripolaire (Q$_2$', Q$_{12}$') de l'élément quadripolaire (Q$_2$, Q$_{12}$) directement avant au moins une image anamorphosée (6,6'), de sorte que son rapport d'aspect soit considérablement agrandi, néanmoins la longueur (7) de l'image anamorphosée (6,6') ne soit pas dépassée, de sorte que la qualité d'image soit dégradée d'une manière, qui serait d'une quelconque manière un inconvénient pour l'estimation d'image.

**12.** Dispositif selon la revendication 11, **caractérisé en ce que** l'élément de décalage de phase (11,12) est conçu pour générer un champ magnétique ou électrique (9,9') provoquant un décalage de phase d'approximativement 90°.

**13.** Dispositif selon la revendication 11, **caractérisé en ce que** après ce dernier sur l'axe optique (10) un deuxième dispositif (1') est disposé, dont les éléments quadripolaires (Q$_{11}$, Q$_{12}$, Q$_{13}$, Q$_{14}$, Q$_{15}$) correspondent aux éléments quadripolaires (Q$_1$, Q$_2$, Q$_3$, Q$_4$, Q$_5$) du premier dispositif (1), dont les champs (Q$_{11}$, Q$_{12}$', Q$_{13}$', Q$_{14}$', Q$_{15}$') sont néanmoins polarisés inversement, de sorte que l'image anamorphosée (6') est tournée à 90° par rapport à l'image anamorphosée (6) du premier dispositif (1), **en ce que** la totalité du dispositif (2) composé du premier (1) et du deuxième dispositif (1') peut être disposé dans le trajet de rayons du système de lentille projective (18) du microscope électronique (31), **en ce que** l'image intermédiaire (5) est située avant le premier élément quadripolaire (Q$_1$) et dans le plan de symétrie (32) à central généré par cet assemblage une image intermédiaire supplémentaire (5') de l'agrandissement M est formée et l'élément à décalage de phase (11,12) du deuxième dispositif (1') est disposé de telle sorte qu'il fournisse des champs magnétiques ou électriques (9,9') pour le décalage de phase relatif entre la zone (14) du rayon d'électrons d'ordre de diffraction zéro (13) et les rayons d'électrons d'ordres de diffraction supérieurs (15) de cette deuxième image anamorphosée (6').

**14.** Dispositif (3) pur mettre en oeuvre le procédé selon une des revendications 1 à 10, avec des éléments quadripolaires du côté d'entrée (Q$_1$, Q$_2$), qui génèrent à partir d'une image intermédiaire (5) des champs quadripolaires (Q$_1$', Q$_2$') tels que les rayons axiaux (x$_\alpha$, y$_\beta$) et les rayons de champ (x$_\gamma$, y$_\delta$) soient focalisés, resp. défocalisés dans deux intersections perpendiculaires (x et y), de sorte que dans un plan d'image intermédiaire de diffraction (8) les rayons axiaux (x$_\alpha$, y$_\beta$) forment une image anamorphosée (6) et les rayons de champ (x$_\gamma$, y$_\delta$) passent respectivement par zéro, dans lequel au niveau du plan d'image intermédiaire de diffraction (8) un élément quadripolaire central (Q$_3$) avec un champ quadripolaire (Q$_3$') est disposé, tel que les rayons axiaux (x$_\alpha$, y$_\beta$) quittent le champ (Q$_3$') avec des élévations, qui s'étendent en sens opposé par rapport à l'entrée dans le champ (Q$_3$'), et dans lequel dans le plan d'image intermédiaire de diffraction (8) un élément de décalage de phase (11,12) est disposé, dont le champ magnétique ou électrique (9,9') est conçu de telle sorte qu'un décalage de phase relatif entre la zone (14) du rayon d'électrons d'ordre de diffraction zéro (13) et les rayons d'électrons d'ordres de diffraction supérieurs (15) soit provoqué, **caractérisé en ce que**

un élément quadripolaire (Q$_4$) est disposé après le plan intermédiaire de diffraction (8) et les éléments quadripolaires (Q$_2$, Q$_4$) disposés directement avant et après le plan d'image intermédiaire de diffraction présentent une expansion telle dans la direction de l'axe optique (10) et une intensité telle qu'ils génèrent une image intermédiaire astigmate (16) dans leur zone d'action, dans lequel l'intensité est choisie à une grandeur telle que l'expansion de champ axiale soit intégrée dans le système optique d'un microscope électronique (31), qu'après un plan de symétrie central (33) par rapport à tous les éléments quadripolaires trois éléments quadripolaires (Q$_{12}$, Q$_{13}$, Q$_{14}$) suivent, dont les champs (Q$_{12}$', Q$_{13}$', Q$_{14}$') sont tournés dans essentiellement la même proportion que les champs (Q$_2$', Q$_3$', Q$_4$') des trois éléments quadripolaires situés avant (Q$_2$, Q$_3$, Q$_4$) néanmoins à 90°, qu'ensuite un quadripôle (Q$_{15}$) avec un champ (Q$_{15}$') suit, qui est de même proportion mais tourné à 90° par rapport au champ (Q$_1$') du premier quadripôle (Q$_1$), que les champs (Q$_2$') et (Q$_4$') des éléments quadripolaires (Q$_2$, Q$_4$) situés avant et après le plan d'image intermédiaire de diffraction (8) sont réglables de manière à s'écarter les uns des autres, de sorte que les rayons axiaux (x$_\alpha$, y$_\beta$) dans le plan de symétrie central (33) forment une image intermédiaire supplémentaire (5') de l'agrandissement M et les rayons de champ (x$_\gamma$, y$_\delta$) se coupent en intersection, et dans lequel les éléments quadripolaires correspondants (Q$_{12}$, Q$_{14}$) après le plan de symétrie central (33), dont les champs (Q$_{12}$', Q$_{14}$') sont tournés à 90°, sont également réglables de manière à s'écarter, de sorte qu'à l'extrémité du dispositif (3) une troisième image intermédiaire (5'') de grandeur M soit générée, de sorte que les rayons axiaux (x$_\alpha$, y$_\beta$) et les rayons de champ (x$_\gamma$, y$_\delta$) traversent ces champs (Q$_{12}$', Q$_{13}$', Q$_{14}$' Q$_{15}$') en coupe x comme les quatre premiers champs (Q$_1$', Q$_2$', Q$_3$', Q$_4$') en coupe y et en coupe y comme précédemment en coupe x, dans lequel dans le deuxième élément quadripolaire central (Q$_{13}$) un deuxième plan d'image intermédiaire de diffraction avec une image anamorphosée supplémentaire (6') est généré, qui est tourné à 90° par rapport à la première image anamorphosée (6), que dans le deuxième plan d'image intermédiaire de diffraction un deuxième élément de décalage de phase (11,12) est disposé, dont le champ magnétique ou électrique (9,9') est conçu de telle sorte qu'un décalage de phase relatif entre une zone (14) du rayon d'électrons d'ordre de diffraction zéro (13) et les rayons d'électrons d'ordres de diffraction supérieurs (15) soit provoqué, et **en ce que** le dispositif (3) est conçu pour une disposition à un premier emplacement du rayon d'électrons d'un système de lentille projective (18) d'un microscope électronique (31), auquel les rayons axiaux (x$_\alpha$, y$_\beta$) forment une image intermédiaire (5) avec un agrandissement M tellement prononcé qu'ils s'étendent dans le champ quadripolaire (Q$_2$') du deuxième quadripôle (Q$_2$) avec une telle déclivité 1/M directement avant l'image anamorphosée (6), de sorte que leur rapport d'aspect soit considérablement agrandi, néanmoins la longueur (7) de l'image anamorphosée (6) ne soit pas dépassée, de sorte que la qualité d'image soit dégradée d'une manière, qui serait d'une quelconque manière un inconvénient pour l'estimation d'image.

**15.** Dispositif selon la revendication 13 ou 14, **caractérisé en ce que** les éléments de décalage de phase (11,12) présentent des champs magnétiques ou électriques (9,9'), qui provoquent un décalage de phase d'approximativement 45° respectivement.

**16.** Dispositif selon une des revendications 11 à 15, **caractérisé en ce que** au moins un élément de décalage de phase (11) est conçu de telle sorte qu'avec lui un champ magnétique ou électrique (9) puisse être appliqué dans la zone (14) du rayon neutre (13) et la zone des rayons diffractés (15) soit placée au potentiel zéro.

**17.** Dispositif selon la revendication 16, **caractérisé en ce que** l'élément de décalage de phase (11) est conçu pour produire un champ électrique (9) comme un conducteur blindé (20), qui est disposé en s'étendant à partir d'une fixation sur la paroi de boîtier à partir du du plan d'image intermédiaire de diffraction (8,8') essentiellement radialement dans la direction de la zone (14) du rayon neutre (13), dans lequel le conducteur blindé (20) présente avant la zone (14) du rayon neutre (13) une extrémité (21) positionnée de telle sorte qu'entre le conducteur (20) et le blindage (22) qui l'entoure un champ électrique (9) soit formé, qui détecte cette zone (14) du rayon neutre (13).

**18.** Dispositif selon une des revendications 11 à 17, **caractérisé en ce que** au moins un élément de décalage de phase (12) est conçu de telle sorte que la zone (14) du rayon neutre (13) est située au potentiel zéro (19) et un champ magnétique ou électrique (9') peut être appliqué au niveau des rayons diffractés (15).

**19.** Dispositif selon la revendication 18, **caractérisé en ce que** l'élément de décalage de phase (12) présente pour générer un champ électrique (9) une fente (23), qui englobe l'image anamorphosée (6,6'), dans lequel des deux côtés le long de la fente (23) s'étendent des électrodes (24,24') pour l'application du champ électrique (9'), qui sont interrompues pour la zone (14) du rayon neutre (13) au niveau de l'axe optique (10) par respectivement un conducteur (25,25') situé au potentiel zéro (19).

**20.** Dispositif selon la revendication 19, **caractérisé en ce que** il est conçu de telle sorte que les quadripôles (Q$_2$, Q$_4$, Q$_{12}$, Q$_{14}$) génèrent à l'avant et à l'arrière du plan intermédiaire de diffraction (8,8') des champs (Q$_2$', Q$_4$', Q$_{12}$', Q$_{14}$') tels que la largeur (7') de l'image anamorphosée (6, 6) s'adapte à la largeur (26) de la fente (23).

**21.** Dispositif selon une des revendications 11 à 20, **caractérisé en ce que** avec les quadripôles (Q$_2$, Q$_4$, Q$_{12}$, Q$_{14}$) des intensités de champ (Q$_2$', Q$_4$', Q$_{12}$', Q$_{14}$') peuvent être générées, et la disposition du dispositif (1,2,3) à un tel emplacement du trajet de rayons du système de lentille projective (18) d'un microscope électronique (31) peut être entreprise, qui présente un agrandissement M de l'image intermédiaire (5) tel qu'une déclivité 1/m des rayons axiaux (x$_\alpha$, y$_\beta$) en résulte, telle que le rapport d'aspect d'au moins une image anamorphosée (6,6') soit supérieur à 100.

**22.** Dispositif selon la revendication 21, **caractérisé en ce que** avec les quadripôles (Q$_2$, Q$_4$, Q$_{12}$, Q$_{14}$) des intensités de champ (Q$_2$', Q$_4$', Q$_{12}$', Q$_{14}$') peuvent être générées, et la disposition du dispositif (1,2,3) à un tel emplacement du trajet de rayons du système de lentille projective (18) d'un microscope électronique (31) peut être entreprise, qui présente un agrandissement M de l'image intermédiaire (5) tel qu'une déclivité 1/m des rayons axiaux (x$_\alpha$, y$_\beta$) en résulte, telle que le rapport d'aspect d'au moins une image anamorphosée (6,6') soit supérieur à 200.

Fig.1

Fig.2

Fig.2a

EP 2 224 465 B1

Fig.2b

Fig.3

Fig.4

Fig.5

Fig.6

Fig.6a

Fig.7

Fig.7a

Fig.7b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006055510 A1

- DE 102007007923 A1

**In der Beschreibung aufgeführte Nicht-Patentliteratur**

- **Z. B. REIMER ; KOHL.** Transmission Electron Microscopy. 2008, 211 ff